# EUROPEAN PATENT APPLICATION

(11) **EP 4 620 619 A1**
(43) Date of publication of application: **24.09.2025**
(21) Application number: 23889874.6
(22) Date of filing: 27.10.2023
(51) Int. Cl.: B24B 49/12, B23Q 17/24, B24B 27/06, B24B 49/04, G01B 11/24, H01L 21/301

(54) **MACHINING DEVICE**

(30) Priority: 17.11.2022 JP 2022184224
(71) Applicant: Tokyo Seimitsu Co., Ltd., Hachioji-shi, Tokyo 192-8515 (JP)
(72) Inventor: TSUSHIMA, Takeo, Hachioji-shi, Tokyo 192-8515 (JP)
(74) Representative: Grünecker Patent- und Rechtsanwälte PartG mbB
(86) International application number: PCT/JP2023/038888
(87) International publication number: WO 2024/106179

(57) **Abstract**

Provided is a machining device capable of precisely measuring a shape of a machined workpiece. The machining device includes: a table configured to hold a workpiece on a holding surface perpendicular to a Z-axis; a machining unit configured to machine the workpiece on the table; an imaging unit configured to image a surface of the workpiece using an optical interferometry; a drive unit configured to move the imaging unit along a direction of the Z-axis relative to the table; and an imaging control unit configured to control the drive unit and the imaging unit to image the surface of the workpiece on the table through scanning in the direction of the Z-axis. The imaging control unit picks up an image of the surface of the workpiece through scanning in the direction of the Z-axis, in accordance with an imaging condition determined for each site to be imaged.

## Description

### BACKGROUND OF THE INVENTION

### Field of the Invention

The present invention relates to a machining device, and particularly to a machining device equipped with an imaging unit which performs imaging using an optical interferometry.

### Description of the Related Art

There has been known a dicing device (blade dicer) as a machining device which cuts and machines a workpiece with a blade (ultrathin peripheral cutting edge) attached to a rapidly rotating spindle. Japanese Patent Application Laid-Open No. 2021-084201 (hereinafter referred to as "Patent Literature 1") describes a dicing device equipped with a white-light interferometer. The dicing device described in Patent Literature 1 may measure a shape and the like of a kerf using the white-light interferometer in the device.

### Citation List

### Patent Literature

Patent Literature 1: Japanese Patent Application Laid-Open No. 2021-084201

### SUMMARY OF THE INVENTION

A shape measuring device using an optical interferometry, such as a white-light interferometer, takes a so-called interference image to perform measurement. To take the interference image, light emitted from a light source is split into two split lights, a reference surface is irradiated with one of the split lights, a surface of a measurement object is irradiated with the other of the split lights, and lights reflected from both the surfaces are received with an image sensor.

In a case where a groove is measured by such a shape measuring device using an optical interferometry, reflected light from inside the groove may be faint, and an S/N ratio may be low to cause misrecognition of noise. The measurement of the groove by the shape measuring device using the optical interferometry may also cause pseudo interference fringes due to reflected light inside the groove. Such pseudo interference fringes become a destabilizing factor or a misdetection factor in extracting an intrinsic shape.

The present invention has been made in view of the above-described circumstances, and aims to provide a machining device capable of precisely measuring a shape of a machined workpiece.

For solving the problem, a machining device according to a first aspect includes: a table configured to hold a workpiece on a holding surface perpendicular to a Z-axis; a machining unit configured to machine the workpiece on the table; an imaging unit configured to image a surface of the workpiece using an optical interferometry; a drive unit configured to move the imaging unit relative to the table, along a direction of the Z-axis; and an imaging control unit configured to control the drive unit and the imaging unit to image the surface of the workpiece on the table through scanning in the direction of the Z-axis. The imaging control unit picks up an image of the surface of the workpiece through scanning in the direction of the Z-axis, in accordance with an imaging condition determined for each site to be imaged.

According to a second aspect, in the machining device according to the first aspect, the imaging control unit applies illumination light having a light intensity determined for each site, to pick up the image of the surface of the workpiece.

According to a third aspect, in the machining device according to the first aspect, the imaging control unit performs gain adjustment based on a setting determined for each site, to pick up the image of the surface of the workpiece.

According to a fourth aspect, in the machining device according to the first aspect, the imaging control unit controls an exposure time based on a setting determined for each site, to pick up the image of the surface of the workpiece.

According to a fifth aspect, in the machining device according to the first aspect, the imaging control unit performs gradation correction based on a setting determined for each site, to pick up the image of the surface of the workpiece.

According to a sixth aspect, in the machining device according to the first aspect, the imaging control unit outputs from each pixel, a pixel value falling within an output range determined for each site, to pick up the image of the surface of the workpiece.

According to a seventh aspect, in the machining device according to the first aspect, in a case where a groove machined on a surface of the workpiece is to be imaged, the groove is classified into a first site including the surface of the workpiece, a third site including a bottom surface of the groove, and a second site between the first site and the third site, and the imaging condition is determined for each of the classified sites.

According to an eighth aspect, the machining device according to the first aspect, further includes an image processing unit configured to process the image picked up through scanning in the direction of the Z-axis, and measure a shape of the surface of the workpiece.

According to a ninth aspect, the machining device according to any one of the first to eighth aspects, further includes: a workpiece information acquisition unit configured to acquire workpiece information including information on a shape of a cross-section of the workpiece; and an imaging condition setting unit configured to set the imaging condition based on the workpiece information.

According to a tenth aspect, the machining device according to the ninth aspect, further includes an output range setting unit configured to set an image output range, based on the information on the shape of the cross-section of the workpiece, and the imaging control unit extracts an image within the image output range set by the output range setting unit from the picked up image, and outputs the extracted image.

According to an eleventh aspect, in the machining device according to the first to eighth aspects, further includes an output range setting unit configured to analyze an image obtained through imaging and set an output range, and the imaging control unit extracts an image within the range set by the output range setting unit from the image obtained through imaging and outputs the extracted image.

According to a twelfth aspect, in the machining device according to the eleventh aspect, the output range setting unit analyzes the picked up image to recognize an interface on the workpiece, and sets the recognized interface and a predetermined range, as the output range.

According to a thirteenth aspect, in the machining device according to the twelfth aspect, in a case where a groove machined on the surface of the workpiece is to be imaged, the output range setting unit recognizes the surface of the workpiece, an inner wall surface of the groove and a bottom surface of the groove, and sets a predetermined range including the recognized surfaces, as the output range.

According to a fourteenth aspect, in the machining device according to any one of the first to eighth aspects, the imaging unit images the surface of the workpiece using a white-light interferometry.

According to the present invention, it is possible to precisely measure a shape of a machined workpiece.

### BRIEF DESCRIPTION OF THE DRAWINGS

Figure 1 is a front view showing an embodiment of a dicing device to which the present invention is applied;
Figure 2 is a view showing a schematic configuration of a table;
Figure 3 is a diagram showing a schematic configuration of a first imaging unit;
Figure 4 is a diagram showing a schematic configuration of a second imaging unit;
Figure 5 is a block diagram of a control system of the dicing device;
Figure 6 is a block diagram of functions of an image processing unit;
Figure 7 is a block diagram of an electrical configuration of the first imaging unit;
Figure 8 is a block diagram of an electrical configuration of the second imaging unit;
Figure 9 is a conceptual diagram of light intensity control of illumination light;
Figure 10 is a block diagram of functions relating to the light intensity control for illumination light, in a second camera control unit;
Figure 11 is a flowchart showing a procedure for a kerf shape measurement process;
Figure 12 is a flowchart showing a procedure for an interference image pickup process;
Figure 13 is a block diagram of functions relating to gain control in the second camera control unit;
Figure 14 is a flowchart showing a procedure for an interference image pickup process;
Figure 15 is a block diagram of functions relating to exposure time control in the second camera control unit;
Figure 16 is a flowchart showing a procedure for an interference image pickup process;
Figure 17 is a block diagram of functions relating to gradation correction control in the second camera control unit;
Figures 18A, 18B, 18C and 18D are graphs showing examples of a gradation correction setting;
Figure 19 is a flowchart showing a procedure for an interference image pickup process;
Figure 20 is a block diagram of functions relating to pixel value output control in the second camera control unit;
Figure 21 is a flowchart showing a procedure for an interference image pickup process;
Figure 22 is an illustration showing an example of a result of measuring of a kerf in a wafer by a white-light interferometer;
Figure 23 is a conceptual diagram of setting of an image output range;
Figure 24 is a block diagram of functions relating to image output control in the second camera control unit;
Figure 25 is a conceptual diagram of setting of an image output range;
Figures 26A, 26B, 26C and 26D are conceptual diagrams of frame setting;
Figure 27 is a block diagram of an image output control system;
Figure 28 is a diagram showing an example of a case where an image output range is set using a multi-joint frame; and
Figure 29 is a diagram showing another example of a frame for setting the image output range.

### DESCRIPTION OF THE EMBODIMENTS

Preferred embodiments of the present invention will be described below with reference to the accompanying drawings.

### [First Embodiment]

A case where the present invention is applied to a dicing device will be described here as an example. As described above, a dicing device is a device which cuts a wafer with a blade attached to a rapidly rotating spindle. A wafer as a machining object is, for example, a semiconductor wafer. A surface of the semiconductor wafer has many ICs (Integrated Circuits) and the like formed in square regions partitioned with streets in a grid pattern. The dicing device cuts the wafer along each street to obtain chips respectively have ICs and the like thereon. The dicing device is an example of a machining device. The wafer is an example of a workpiece.

### [Device Configuration]

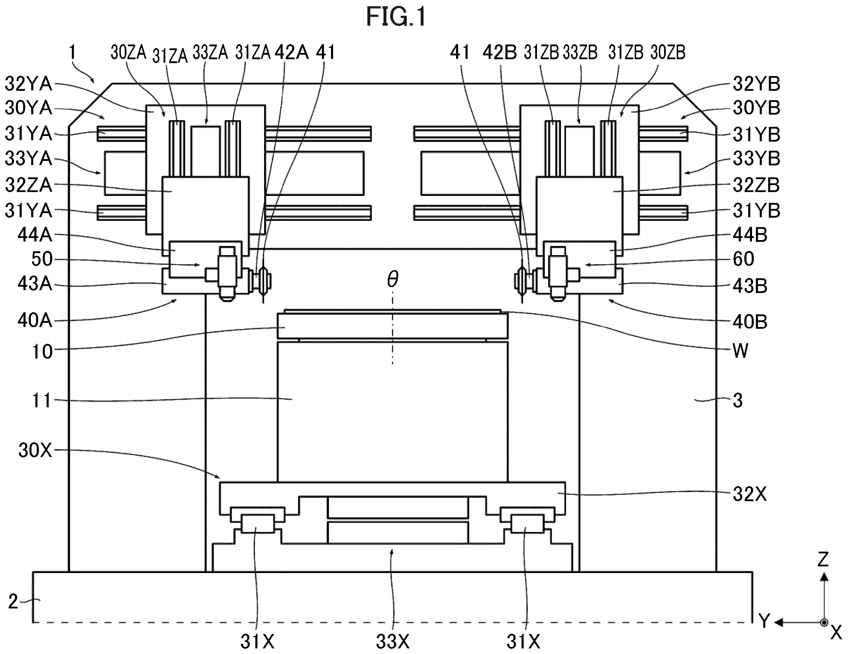

Figure 1 is a front view showing one embodiment of a dicing device to which the present invention is applied. In Figure 1, an X-axis, a Y-axis, and a Z-axis are axes perpendicular to each other. A plane including the X-axis and the Y-axis constitutes a horizontal plane.

A dicing device 1 shown in Figure 1 is a so-called twin-spindle dicer. A twin-spindle dicer is a dicing device including a pair of spindles. The twin-spindle dicer may adopt several machining forms such as dual cutting and step cutting. Dual cutting is a machining method that simultaneously performs full cutting or half cutting on two lines with a pair of blades. Full cutting is a machining method for cutting a machining object tother with a fixing material, such as a dicing tape, to completely sever the machining object. Half cutting is grooving for cutting a machining object into a halfway of a thickness of the machining object. Step cutting is a machining method for performing half cutting and full cutting in two stages.

As shown in Figure 1, the dicing device 1 has a base 2 serving as a pedestal. On the base 2, a table 10 which holds a wafer W, an X-axis feed mechanism 30X which feeds the table 10 in an X-axis direction, and the like are provided.

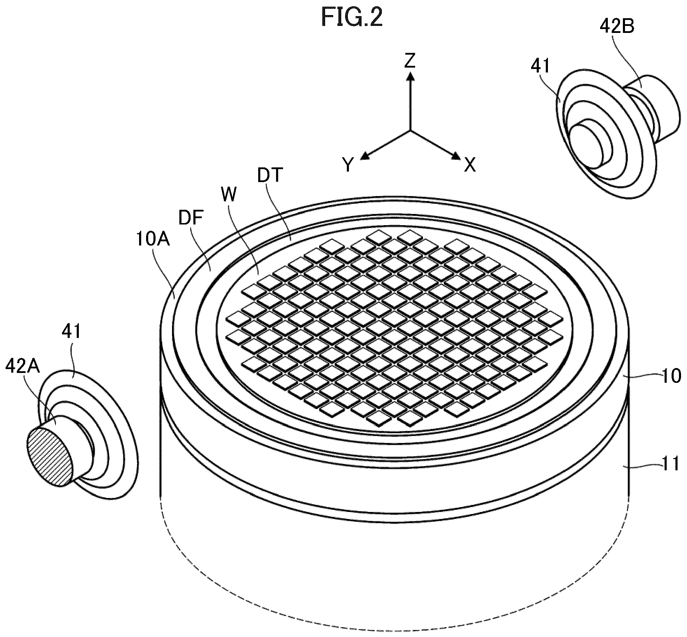

Figure 2 is a view showing a schematic configuration of the table.

As shown in Figure 2, the table 10 has a disc-like shape and holds the wafer W on a horizontal holding surface 10A. By way of example, the table 10 holds the wafer W with vacuum suction.

The wafer W as a machining object is held by the table 10, mounted on a dicing frame DF, as shown in Figure 2. The wafer W has a disc-like shape and is mounted on the dicing frame DF via a dicing tape DT.

The table 10 is driven by a table drive unit 11 and rotates about a θ axis. The θ axis is an axis which passes through a center of the table 10 and is parallel to the Z-axis. The table drive unit 11 includes a motor and a rotational position detector (both not shown). The rotational position detector is provided with, for example, a rotary encoder and detects a rotational position of the table 10.

The X-axis feed mechanism 30X is a mechanism which moves the table 10 in the X-axis direction. As shown in Figure 1, the X-axis feed mechanism 30X is provided with X-axis guide rails 31X, an X-axis table 32X, an X-axis actuator 33X, an X-axis position detector (not shown), and the like. The X-axis guide rails 31X are provided on the base 2 along the X-axis direction. The X-axis table 32X is provided to be movable on the X-axis guide rails 31X. The X-axis actuator 33X moves the X-axis table 32X along the X-axis guide rails 31X. The X-axis actuator 33X is provided with, for example, a linear motor. The X-axis position detector (not shown) detects a position of the X-axis table 32X. The X-axis position detector is provided with, for example, a linear scale.

The table 10 and the table drive unit 11 are arranged on the X-axis table 32X. The X-axis actuator 33X is driven to move the X-axis table 32X in the X-axis direction, so that the table 10 moves in the X-axis direction. The position of the X-axis table 32X is detected with the X-axis position detector (not shown), so as to detect a position of the table 10 in the X-axis direction.

As shown in Figure 1, a gate-shaped column 3 is provided on the base 2 astride (across) the X-axis guide rails 31X. The column 3 is provided with: a first machining unit 40A and a second machining unit 40B which machine the wafer W on the table 10; a first imaging unit 50 and a second imaging unit 60 which image the wafer W on the table 10; a first Y-axis feed mechanism 30YA which feeds the first machining unit 40A and the first imaging unit 50 in a Y-axis direction; a second Y-axis feed mechanism 30YB which feeds the second machining unit 40B and the second imaging unit 60 in the Y-axis direction; a first Z-axis feed mechanism 30ZA which feeds the first machining unit 40A and the first imaging unit 50 in a Z-axis direction; a second Z-axis feed mechanism 30ZB which feeds the second machining unit 40B and the second imaging unit 60B in the Z-axis direction; and the like.

The first machining unit 40A cuts and machines the wafer W with a rapidly rotating blade 41. The first machining unit 40A includes a first spindle 42A to which the blade 41 is attached, a first spindle motor 43A which rotates the first spindle 42A, and the like. The first spindle 42A is arranged parallel to the Y-axis. The first spindle 42A includes a blade attachment part at a distal end part thereof. The blade 41 is removably attached to the blade attachment part. The first spindle motor 43A is driven to rapidly rotate the first spindle 42A, so that the blade 41 attached to the first spindle 42A rapidly rotates about an axis.

The second machining unit 40B cuts and machines the wafer W with a rapidly rotating blade 41. The second machining unit 40B includes a second spindle 42B to which the blade 41 is attached, a second spindle motor 43B which rotates the second spindle 42B, and the like. The second spindle 42B is arranged parallel to the Y-axis. The second spindle 42B includes a blade attachment part at a distal end part thereof. The blade 41 is removably attached to the blade attachment part. The second spindle motor 43B is driven to rapidly rotate the second spindle 42B, so that the blade 41 attached to the second spindle 42B rapidly rotates about an axis.

The first imaging unit 50 is an imaging unit for alignment. The first imaging unit 50 images a part of a surface of the wafer W on the table 10 in a magnified manner, from directly above the surface of the wafer W.

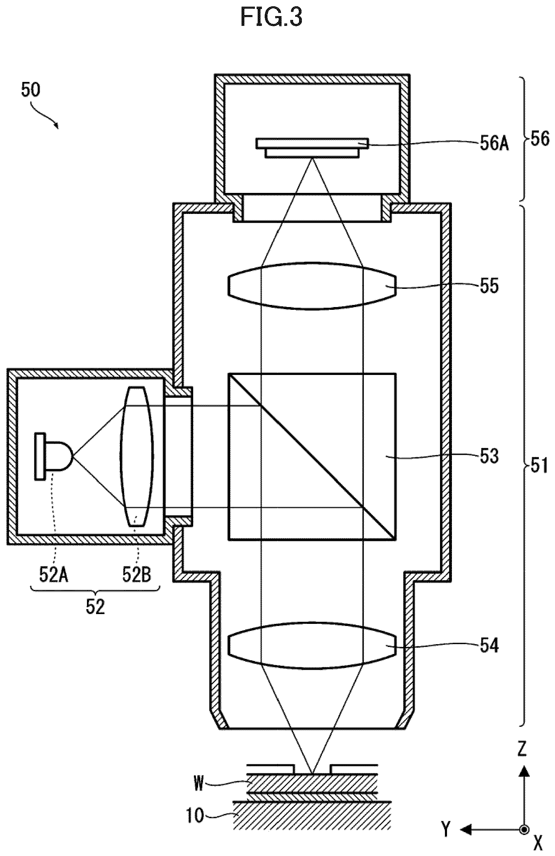

Figure 3 is a diagram showing a schematic configuration of the first imaging unit.

The first imaging unit 50 includes a first microscopic unit 51 and a first camera unit 56. The first imaging unit 50 picks up (takes) an image magnified by the first microscopic unit 51 with the first camera unit 56.

The first microscopic unit 51 includes an illumination unit 52, a beam splitter 53, an objective lens 54, an imaging lens 55, and the like.

The illumination unit 52 has an illumination light source 52A and an illumination lens 52B. The illumination unit 52 emits, via the illumination lens 52B, light (illumination light) emitted from the illumination light source 52A. For example, a halogen lamp, a metal halide lamp, a mercury lamp, a xenon lamp, a light emitting diode (LED), or the like may be used as the illumination light source 52A.

The wafer W on the table 10 is irradiated with the light emitted from the illumination unit 52 via the beam splitter 53 and the objective lens 54. The light reflected by the wafer W comes incident on the first camera unit 56 via the objective lens 54, the beam splitter 53, and the imaging lens 55.

The first camera unit 56 has an imaging element 56A and electronically picks up an image magnified by the first microscopic unit 51. For example, an area image sensor, such as a CMOS image sensor (complementary metal oxide semiconductor image sensor) or a CCD image sensor (charge-coupled device image sensor), may be used as the imaging element 56A. An image picked up by the first camera unit 56 is output to an image processing unit 110.

The second imaging unit 60 is an imaging unit for measurement. The second imaging unit 60 images the surface of the wafer W using an optical interferometry. In the present embodiment, in particular, the surface of the wafer W is imaged using a white-light interferometry in which white light is used for a light source. The surface of the wafer W is scanned in the Z-axis direction (height direction) and imaged using the white-light interferometry, so that a shape of the surface of the wafer W may be measured. Since the second imaging unit 60 images the surface of the wafer W using the white-light interferometry, the second imaging unit 60 substantially constitutes a white-light interferometer.

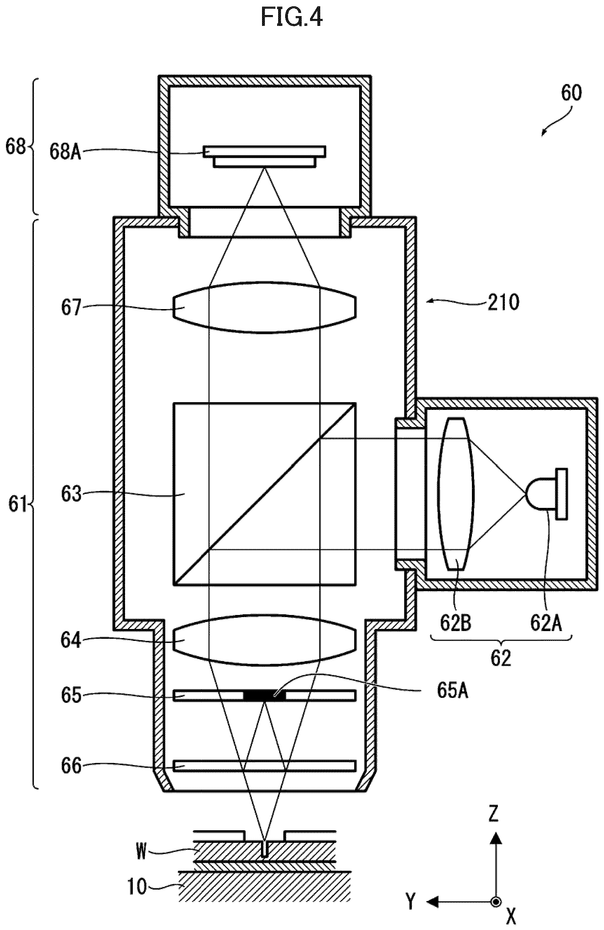

Figure 4 is a diagram showing a schematic configuration of the second imaging unit.

The second imaging unit 60 includes a second microscopic unit 61 and a second camera unit 68. The second imaging unit 60 picks up an image (interference image) observed by the second microscopic unit 61 with the second camera unit 68. The second imaging unit 60 images the surface of the wafer W along the Z-axis direction from above the table 10.

The second microscopic unit 61 is provided with a white-light interference microscope. In the present embodiment, the second microscopic unit 61 is provided with a so-called Mirau-type white-light interference microscope. As shown in Figure 4, the second microscopic unit 61 includes an illumination unit 62, a first beam splitter 63, an objective lens 64, a glass plate 65, a second beam splitter 66, an imaging lens 67, and the like. The glass plate 65 has a reference mirror 65A at a central part of the glass plate 65. The objective lens 64, the glass plate 65, and the second beam splitter 66 constitute an interference optical system.

The illumination unit 62 has an illumination light source 62A and an illumination lens 62B. The illumination unit 62 emits, via the illumination lens 62B, white light emitted from the illumination light source 62A. For example, a halogen lamp, an LED, or the like may be used as the illumination light source 62A.

White light emitted from the illumination unit 62 comes incident on the second beam splitter 66 via the first beam splitter 63, the objective lens 64, and the glass plate 65. The white light incident on the second beam splitter 66 is separated into measurement light and reference light by the second beam splitter 66.

The measurement light passes through the second beam splitter 66 and comes incident on the surface of the wafer W. The measurement light reflected on the surface of the wafer W comes incident on the second camera unit 68 via the second beam splitter 66, the glass plate 65, the objective lens 64, the first beam splitter 63, and the imaging lens 67.

The reference light is reflected by the second beam splitter 66 to come incident on the glass plate 65. The reference light incident on the glass plate 65 is reflected by the reference mirror 65A to come incident on the second beam splitter 66 again. The reference light is reflected by the second beam splitter 66 again to come incident on the second camera unit 68 via the glass plate 65, the objective lens 64, the first beam splitter 63, and the imaging lens 67.

The measurement light reflected on the surface of the wafer W and incident on the second camera unit 68 overlaps with the reference light reflected by the reference mirror 65A and incident on the second camera unit 68, to generate interference light. The interference optical system includes the objective lens 64, the glass plate 65, and the second beam splitter 66, and is designed such that the measurement light and the reference light are equal in optical path length when a measurement object is in focus.

The second camera unit 68 has an imaging element 68A and electronically picks up an image (interference image) generated by the second microscopic unit 61. For example, an area image sensor, such as a CMOS image sensor or a CCD image sensor, may be used as the imaging element 68A. An image (interference image) picked up by the second camera unit 68 is output to the image processing unit 110.

In a case where the second imaging unit 60 is moved along the Z-axis direction (height direction), an optical path length of the measurement light reflected on the surface of the wafer W changes. Interference intensity of interference light incident on the imaging element 68A is the highest in a case where both optical path lengths coincide. Thus, positions of projections and depressions on the surface of the wafer W may be measured by reading, for each pixel, a position in the Z-axis direction at which interference intensity is the highest.

The first Y-axis feed mechanism 30YA is a mechanism which moves the first machining unit 40A and the first imaging unit 50 in the Y-axis direction. As shown in Figure 1, the first Y-axis feed mechanism 30YA is provided with first Y-axis guide rails 31YA, a first Y-axis table 32YA, a first Y-axis actuator 33YA, a first Y-axis position detector (not shown), and the like. The first Y-axis guide rails 31YA are laid on the column 3 along the Y-axis direction. The first Y-axis table 32YA is provided to be movable on the first Y-axis guide rails 31YA. The first Y-axis actuator 33YA moves the first Y-axis table 32YA along the first Y-axis guide rails 31YA. The first Y-axis actuator 33YA is provided with, for example, a linear motor. The first Y-axis position detector (not shown) detects a position of the first Y-axis table 32YA. The first Y-axis position detector is provided with, for example, a linear scale.

The second Y-axis feed mechanism 30YB is a mechanism which moves the second machining unit 40B and the second imaging unit 60 in the Y-axis direction. As shown in Figure 1, the second Y-axis feed mechanism 30YB is provided with second Y-axis guide rails 31YB, a second Y-axis table 32YB, a second Y-axis actuator 33YB, a second Y-axis position detector (not shown), and the like. The second Y-axis guide rails 31YB are laid on the column 3 along the Y-axis direction. The second Y-axis table 32YB is provided to be movable on the second Y-axis guide rails 31YB. The second Y-axis actuator 33YB moves the second Y-axis table 32YB along the second Y-axis guide rails 31YB. The second Y-axis actuator 33YB is provided with, for example, a linear motor. The second Y-axis position detector (not shown) detects a position of the second Y-axis table 32YB. The second Y-axis position detector is provided with, for example, a linear scale.

The first Z-axis feed mechanism 30ZA is a mechanism which moves the first machining unit 40A and the first imaging unit 50 in the Z-axis direction. The first Z-axis feed mechanism 30ZA is provided with first Z-axis guide rails 31ZA, a first Z-axis table 32ZA, a first Z-axis actuator 33ZA, a first Z-axis position detector (not shown), and the like. The first Z-axis guide rails 31ZA are laid on the first Y-axis table 32YA along the Z-axis direction. The first Z-axis table 32ZA is provided to be movable on the first Z-axis guide rails 31ZA. The first Z-axis actuator 33ZA moves the first Z-axis table 32ZA along the first Z-axis guide rails 31ZA. The first Z-axis actuator 33ZA is provided with, for example, a linear motor. The first Z-axis position detector (not shown) detects a position of the first Z-axis table 32ZA. The first Z-axis position detector is provided with, for example, a linear scale.

The second Z-axis feed mechanism 30ZB is a mechanism which moves the second machining unit 40B and the second imaging unit 60 in the Z-axis direction. The second Z-axis feed mechanism 30ZB is provided with second Z-axis guide rails 31ZB, a second Z-axis table 32ZB, a second Z-axis actuator 33ZB, a second Z-axis position detector (not shown), and the like. The second Z-axis guide rails 31ZB are laid on the second Y-axis table 32YB along the Z-axis direction. The second Z-axis table 32ZB is provided to be movable on the second Z-axis guide rails 31ZB. The second Z-axis actuator 33ZB moves the second Z-axis table 32ZB along the second Z-axis guide rails 31ZB. The second Z-axis actuator 33ZB is provided with, for example, a linear motor. The second Z-axis position detector (not shown) detects a position of the second Z-axis table 32ZB. The second Z-axis position detector is provided with, for example, a linear scale.

The first machining unit 40A and the first imaging unit 50 are attached to the first Z-axis table 32ZA via a bracket 44A. Thus, when the first Z-axis table 32ZA is moved, the first machining unit 40A and the first imaging unit 50 move in the Z-axis direction (height direction). When the first Y-axis table 32YA is moved, the first machining unit 40A and the first imaging unit 50 move in the Y-axis direction (lateral direction). With detection of a position in the Z-axis direction of the first Z-axis table 32ZA by the first Z-axis position detector (not shown), it is possible to detect a position in the Z-axis direction of the blade 41 attached to the first spindle 42A and a position in the Z-axis direction of the first imaging unit 50. With detection of a position in the Y-axis direction of the first Y-axis table 32YA by the first Y-axis position detector (not shown), it is possible to detect a position of the blade 41 attached to the first spindle 42A in the Y-axis direction and a position of the first imaging unit 50 in the Y-axis direction.

The second machining unit 40B and the second imaging unit 60 are attached to the second Z-axis table 32ZB via a bracket 44B. Thus, when the second Z-axis table 32ZB is moved, the second machining unit 40B and the second imaging unit 60 move in the Z-axis direction (height direction). When the second Y-axis table 32YB is moved, the second machining unit 40B and the second imaging unit 60 move in the Y-axis direction (lateral direction). With detection of a position in the Z-axis direction of the second Z-axis table 32ZB by the second Z-axis position detector (not shown), it is possible to detect a position in the Z-axis direction of the blade 41 attached to the second spindle 42B and a position in the Z-axis direction of the second imaging unit 60. With detection of a position in the Y-axis direction of the second Y-axis table 32YB by the second Y-axis position detector (not shown), it is possible to detect a position of the blade 41 attached to the second spindle 42B in the Y-axis direction and a position of the second imaging unit 60 in the Y-axis direction.

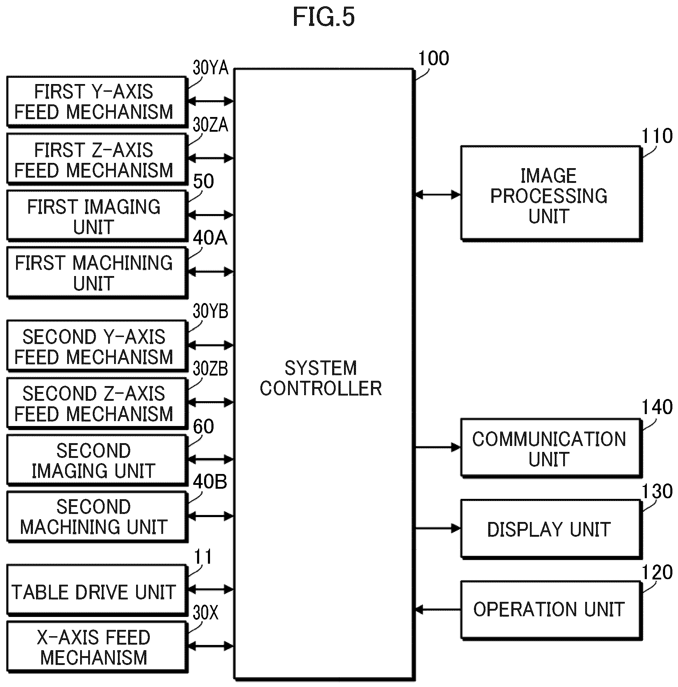

Figure 5 is a block diagram of a control system of the dicing device.

The dicing device 1 has: a system controller 100 which functions as an overall control unit; the image processing unit 110 that processes images picked up by the first imaging unit 50 and the second imaging unit 60; an operation unit 120 for an operator to perform various types of operations; a display unit 130 that displays various types of information; a communication unit 140 that communicates with external equipment; and the like. The form of communication is not particularly limited. Wired communication or wireless communication may be adopted. Alternatively, communication over a network may be adopted.

The system controller 100 is provided with a computer including a processor, a memory, and the like. That is, the computer executes a predetermined program, thereby functioning as the system controller 100. The processor is, for example, a CPU (Central Processing Unit). The memory includes a ROM (Read Only Memory), a flash memory, and the like in addition to a RAM (Random Access Memory).

Regarding operation of the table 10, the system controller 100 controls the table drive unit 11 to control rotation of the table 10. The system controller 100 also controls the X-axis feed mechanism 30X to control feeding in the X-axis direction of the table 10. More specifically, the system controller 100 controls the X-axis actuator 33X based on output from the X-axis position detector (not shown) to control feeding in the X-axis direction of the table 10.

Regarding operation of the first machining unit 40A, the system controller 100 controls the first Y-axis feed mechanism 30YA to control feeding (indexing) of the first machining unit 40A in the Y-axis direction. More specifically, the system controller 100 controls the first Y-axis actuator 33YA based on output from the first Y-axis position detector (not shown) to control feeding of the first machining unit 40A in the Y-axis direction. The system controller 100 also controls the first Z-axis feed mechanism 30ZA to control feeding of the first machining unit 40A in the Z-axis direction. More specifically, the system controller 100 controls the first Z-axis actuator 33ZA based on output from the first Z-axis position detector (not shown) to control feeding of the first machining unit 40A in the Z-axis direction. The system controller 100 further controls the first spindle motor 43A to control driving of the first spindle 42A.

Regarding operation of the second machining unit 40B, the system controller 100 controls the second Y-axis feed mechanism 30YB to control feeding of the second machining unit 40B in the Y-axis direction. More specifically, the system controller 100 controls the second Y-axis actuator 33YB based on output from the second Y-axis position detector (not shown) to control feeding of the second machining unit 40B in the Y-axis direction. The system controller 100 also controls the second Z-axis feed mechanism 30ZB to control feeding of the second machining unit 40B in the Z-axis direction. More specifically, the system controller 100 controls the second Z-axis actuator 33ZB based on output from the second Z-axis position detector (not shown) to control feeding of the second machining unit 40B in the Z-axis direction. The system controller 100 further controls the second spindle motor 43B to control driving of the second spindle 42B.

With control of feeding in the X-axis direction of the table 10, feeding (cutting feeding, or machining feeding) in a cutting direction is controlled. With control of feeding in the Y-axis direction of the first machining unit 40A and the second machining unit 40B, index-feeding (indexing) in a direction perpendicular to the cutting direction is controlled. Further, with control of feeding in the Z-axis direction of the first machining unit 40A and the second machining unit 40B, feeding (depth feeding or cutting-in feeding) in a cutting-in direction is controlled. The control of feeding in the cutting-in direction leads to control of a cutting-in depth.

The system controller 100 controls the first imaging unit 50 and the second imaging unit 60 to control imaging of the wafer W. The control of imaging will be described later.

The image processing unit 110 is provided with a computer including a processor, a memory, and the like. That is, the computer executes a predetermined program, thereby functioning as the image processing unit 110. Note that the computer constituting the image processing unit 110 and the computer constituting the system controller 100 may be one and the same. That is, a single computer may be made to function as the system controller 100 and the image processing unit 110.

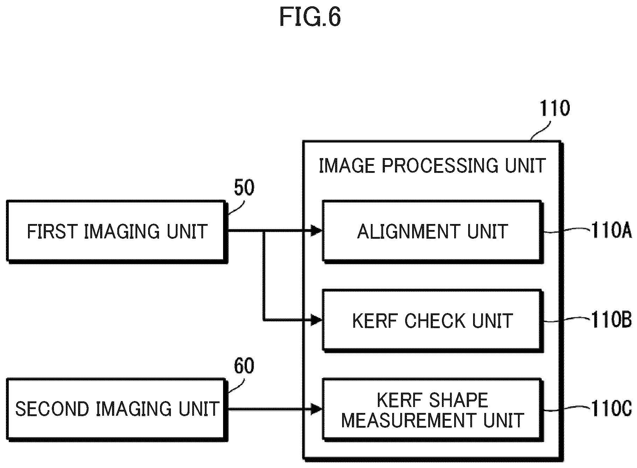

Figure 6 is a block diagram of functions of the image processing unit.

As shown in Figure 6, the image processing unit 110 has functions of an alignment unit 110A, a kerf check unit 110B, a kerf shape measurement unit 110C, and the like.

The alignment unit 110A performs alignment processing in cooperation with the system controller 100. The alignment refers to an operation of detecting positions of streets. The position of each street is detected with reference to, for example, an alignment mark. The alignment mark is a mark for alignment (also called an alignment target) which is put on the surface of the wafer W. The streets are cuttable regions on the wafer W. The image picked up by the first imaging unit 50 is processed to detect an alignment mark in the image. Note that, since this type of technique is publicly known, a description of the details thereof will be omitted.

The kerf check unit 110B performs a kerf check based on the image picked up by the first imaging unit 50. The kerf check refers to a process of confirming whether each blade 41 is appropriately performing machining at a correct position on the wafer W. The kerf check includes detection of misaligned cutting, detection of chipping, detection of a kerf width, and the like. The kerf check is performed on a position set in advance with a frequency set in advance. Note that, since a kerf check using an image itself is a publicly known technique, a description of the details thereof will be omitted.

The kerf shape measurement unit 110C processes an image (interference image) picked up by the second imaging unit 60 to measure a kerf shape. Specifically, the kerf shape measurement unit 110C processes images (e.g., images having different focal planes for an object, from each other) picked up through scanning of the second imaging unit 60 in the Z-axis direction to measure a three-dimensional shape of the measurement object. The measurement object is a kerf which is formed on the surface of the wafer W. As described above, the second imaging unit 60 is provided with a white-light interferometer. Thus, imaging of the measurement object by the second imaging unit 60 through scanning in the Z-axis direction allows measurement of the three-dimensional shape of the measurement object from the obtained images. Note that the process of obtaining a three-dimensional shape of a measurement object from the images picked up by a white-light interferometer itself is a publicly known technique. A description of details of the process will thus be omitted. The kerf shape measurement unit 110C generates and outputs three-dimensional shape data of the measurement object.

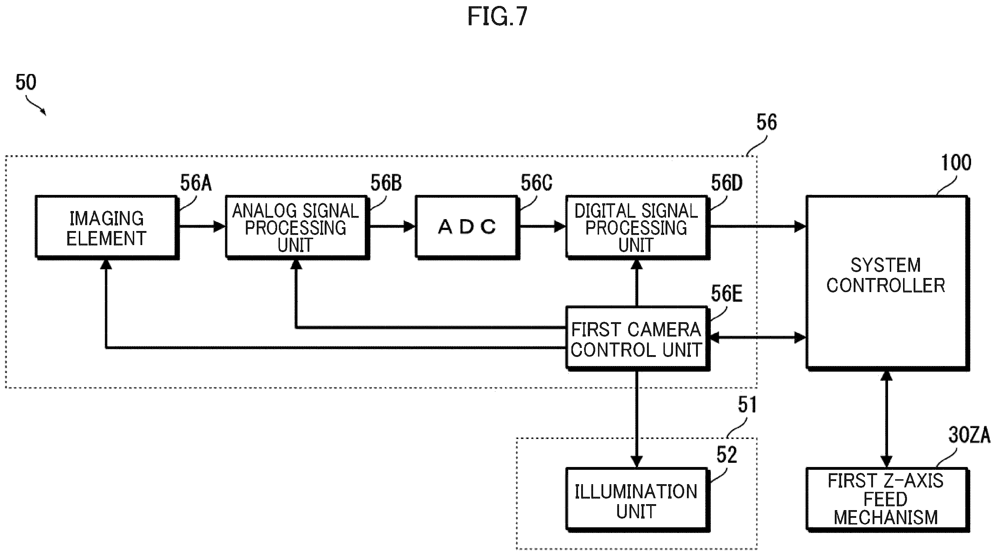

Figure 7 is a block diagram of an electrical configuration of the first imaging unit.

As shown in Figure 7, the first camera unit 56 includes the imaging element 56A, an analog signal processing unit 56B, an ADC (Analog to Digital Converter) 56C, a digital signal processing unit 56D, and a first camera control unit 56E.

The analog signal processing unit 56B performs predetermined analog signal processes, such as correlated double sampling processing and gain adjustment, on the image signal output from the imaging element 56A.

The ADC 56C converts the analog image signal subjected to the predetermined signal processes in the analog signal processing unit 56B to a digital image signal.

The digital signal processing unit 56D performs various types of signal processes. Processes to be performed by the digital signal processing unit 56D include a process of generating image data based on the signal output from the imaging element 56A. The process of generating image data includes processing, such as gradation correction.

The first camera control unit 56E controls the first camera unit 56 and the units of the first microscopic unit 51 to control imaging by the first imaging unit 50. The first camera control unit 56E is provided with a computer including a processor, a memory, and the like.

Control to be performed by the first camera control unit 56E includes AF (Autofocus: automatic focusing) control. The AF control is performed in cooperation with the system controller 100. That is, scanning in the Z-axis direction is performed to detect a position (in-focus position) where the surface of the wafer W is in focus. The detection of the in-focus position is performed by, for example, a contrast method (so-called contrast AF). The detection of the in-focus position for the surface of the wafer W allows detection of a height position (a position in the Z-axis direction) of the surface of the wafer W.

Control of the first microscopic unit 51 performed by the first camera control unit 56E is control of the illumination unit 52, more specifically control of the illumination light source 52A of the illumination unit 52. The first camera control unit 56E controls a light intensity (brightness) of illumination light emitted from the illumination light source 52A.

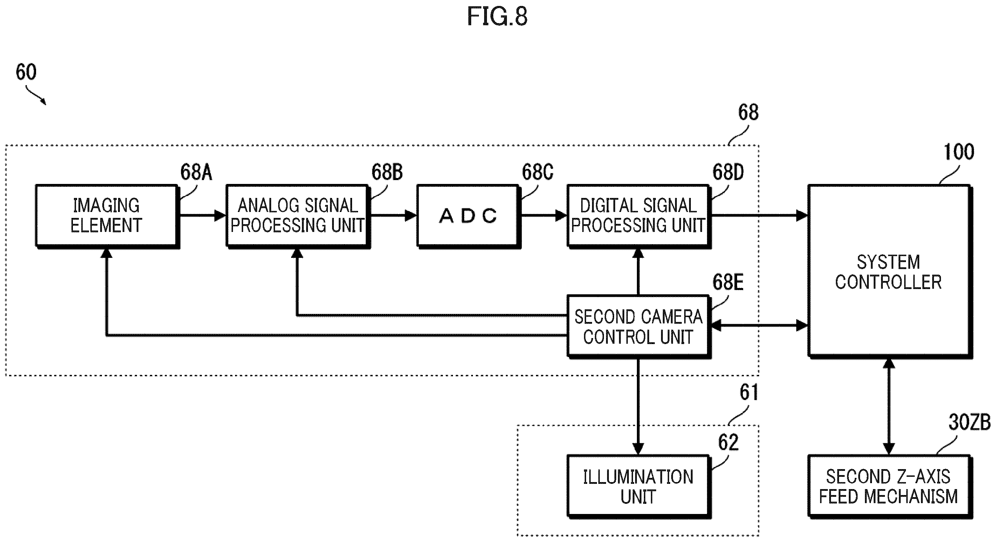

Figure 8 is a block diagram of an electrical configuration of the second imaging unit.

As shown in Figure 8, the second camera unit 68 includes the imaging element 68A, an analog signal processing unit 68B, an ADC 68C, a digital signal processing unit 68D, and a second camera control unit 68E.

The analog signal processing unit 68B performs predetermined analog signal processes, such as correlated double sampling processing and gain adjustment, on an image signal output from the imaging element 68A.

The ADC 68C converts an analog image signal subjected to the predetermined signal processes in the analog signal processing unit 68B to a digital image signal.

The digital signal processing unit 68D performs various types of signal processes. Processes to be performed by the digital signal processing unit 68D include a process of generating image data based on a signal output from the imaging element 68A. The process of generating image data includes processing, such as gradation correction.

The second camera control unit 68E controls the second camera unit 68 and the units of the second microscopic unit 61 to control imaging by the second imaging unit 60. The second camera control unit 68E is provided with a computer including a processor, a memory, and the like.

The control of imaging is performed in cooperation with the system controller 100. As described above, imaging by the second imaging unit 60 is performed through scanning in the Z-axis direction. For this reason, movement in the Z-axis direction is controlled by the system controller 100, and imaging at each position is controlled by the second camera control unit 68E. Thus, in the present embodiment, the second camera control unit 68E and the system controller 100 constitute an imaging control unit.

Control of the second microscopic unit 61 performed by the second camera control unit 68E is control of the illumination unit 62, more specifically control of the illumination light source 62A of the illumination unit 62. The second camera control unit 68E controls a light intensity (brightness) of illumination light emitted from the illumination light source 62A. In the present embodiment, in particular, a measurement object is divided (classified) into a plurality of sites along a scanning direction, and control is performed such that a light intensity of illumination light changes depending on a site to be imaged. A site is a part which occupies a certain position in the whole scanning range. Each site is set as a part which may be imaged under the same condition. In the present embodiment, a measurement object is divided into a plurality of sites along the scanning direction as parts which may be imaged at the same light intensity of illumination light.

Control of a light intensity of illumination light corresponding to a site to be imaged (imaging site) will be described below.

In a case where a groove is measured by the shape measuring device using an optical interferometry, such as a white-light interferometer, reflected light from inside the groove may be feeble (faint), and an S/N ratio between desired interference fringes and noise may be small. This may result in misrecognition of noise.

For the above-described reason, in the present embodiment, a light intensity of illumination light is changed depending on an imaging site (measurement site), in imaging through scanning in the Z-axis direction.

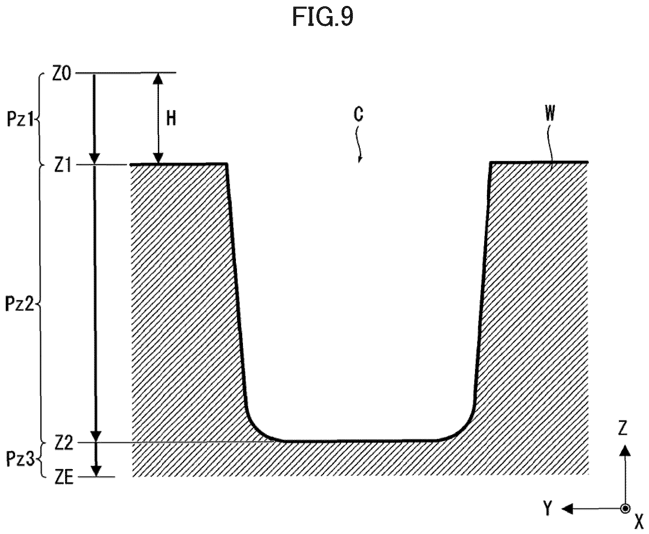

Figure 9 is a conceptual diagram of light intensity control of illumination light. Figure 9 shows an example of a case where a shape of a kerf C formed in the surface of the wafer W is measured.

Consider a case where the kerf C is imaged for the wafer W on the table 10 while the second imaging unit 60 is moved vertically downward (Z-axis scanning). The imaging is started at an imaging start position Z0. The imaging start position Z0 is set to a position at a predetermined height H from the surface of the wafer W. Note that a position Z1 is a position of the surface of the wafer W in Figure 9. A position Z2 is a position of a bottom surface of the kerf C. A position ZE is an imaging end position. The imaging end position is set to a position at a predetermined distance from the position of the bottom surface of the kerf C.

In the present embodiment, a measurement object is divided into three sites along the scanning direction, and a light intensity of illumination light is set for each site. Specifically, assume that a site to the surface of the wafer W is a first site Pz1 (Z1 ≤ Pz1 ≤ Z0), a site from the surface of the wafer W to the bottom surface of the kerf C is a second site Pz2 (Z2 < Pz2 < Z1), and a site from the bottom surface of the kerf C is a third site Pz3 (Pz3 ≤ Z2). The light intensity of illumination light is set for each site.

Assume that the light intensity of illumination light in imaging the first site Pz1 is a first light intensity LV1, the light intensity of illumination light in imaging the second site Pz2 is a second light intensity LV2, and the light intensity of illumination light in imaging the third site Pz3 is a third light intensity LV3.

Imaging of the first site Pz1 is no different from ordinary cases where the measurement object is imaged in the air. Thus, the first light intensity LV1 is set to the same light intensity as in ordinary cases where the measurement object is imaged in the air.

Imaging of the second site Pz2 is imaging of an inside of the kerf C. Thus, the second light intensity LV2 is set to a value higher than the first light intensity LV1 (LV1 < LV2).

The third site Pz3 is imaging of the bottom surface of the kerf C. Thus, the third light intensity LV3 is preferably set in accordance with a state of the bottom surface of the kerf C. In a case where the bottom surface is a smooth surface, reflected light may be obtained from the bottom surface. In this case, the third light intensity LV3 is set to a value between the first light intensity LV1 and the second light intensity LV2 (LV1 < LV3 < LV2). In a case where the bottom surface is not a smooth surface (there is little reflected light from the bottom surface or the bottom surface is darker than an inner wall surface of the kerf C) or in a case where the bottom surface is a smooth surface but is at a deep depth (the depth is equal to or more than a threshold), a light intensity of reflected light is lower than in the second site Pz2. Thus, in this case, the third light intensity LV3 is set to a value higher than the second light intensity LV2 (LV2 < LV3).

The second camera control unit 68E acquires information including: information on a machining shape of the kerf C (information on a shape of cross section of the kerf C); and information (workpiece information) on the state of the bottom surface of the kerf C. Then, the second camera control unit 68E performs setting of sites and setting of light intensity of illumination light for each site, based on the acquired workpiece information. The second camera control unit 68E controls the illumination unit 52 based on the set sites and the light intensity for each site.

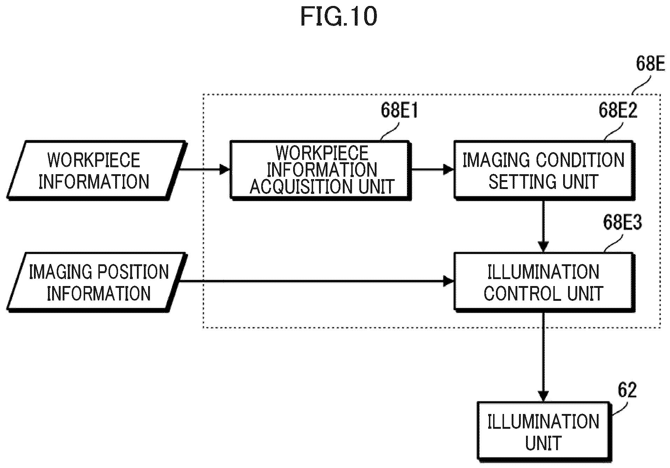

Figure 10 is a block diagram of functions relating to the light intensity control for illumination light, in the second camera control unit.

As shown in Figure 10, the second camera control unit 68E has functions of a workpiece information acquisition unit 68E1, an imaging condition setting unit 68E2, and an illumination control unit 68E3.

The workpiece information acquisition unit 68E1 acquires workpiece information. As described above, the workpiece information includes; information on the machining shape of the kerf C; and information on the state of the bottom surface of the kerf C. The workpiece information acquisition unit 68E1 acquires the workpiece information from the system controller 100. The system controller 100 acquires the workpiece information from an operator. The operator inputs the workpiece information via the operation unit 120 or the communication unit 140.

As information on the machining shape of the kerf C (a so-called cross-sectional profile, cross-sectional shape), for example, information obtained through a simulation or the like may be used. In a case where the blade 41 to be used and a cutting-in depth are known, a cross-sectional shape (theoretical cross-sectional shape) of a kerf C to be formed is also known. Thus, the machining shape of the kerf C is obtained through a simulation or the like, and the information is used as the machining shape information.

Note that the system controller 100 may be configured so as to acquire information on the blade 41 to be used and information on the cutting-in depth from the operator, and automatically calculate information on the machining shape of the kerf C based on the acquired information.

In addition, a kerf C machined under the same condition may be measured, and a result of the measurement may be used as machining shape information of the object.

Alternatively, a workpiece surface may be obtained by AF, a vicinity of the third site Pz3 may be scanned with the third light intensity LV3 so as to obtain the third site Pz3 first, and then a zone for the second site Pz2 may be determined.

The imaging condition setting unit 68E2 sets an imaging condition based on workpiece information. In the present embodiment, a light intensity of illumination light to be emitted from the illumination unit 62 is set for each of the sites to be imaged. Specifically, the kerf C is divided into three sites (the first site Pz1, the second site Pz2, and the third site Pz3) along the Z-axis direction, and light intensities (the first light intensity VL1, the second light intensity VL2, and the third light intensity VL3) of illumination light at the time of imaging are respectively set for the sites.

Information on a setting condition (light intensity setting condition) for light intensity determined for each site is stored in, for example, a memory.

The illumination control unit 68E3 controls a light intensity of illumination light to be emitted from the illumination unit 62 in accordance with the light intensity setting condition set by the imaging condition setting unit 68E2. More specifically, the illumination control unit 68E3 controls the illumination light source 62A of the illumination unit 62 to control the light intensity of illumination light to be emitted from the illumination light source 62A. The illumination control unit 68E3 controls the illumination light source 62A based on imaging position information such that illumination light is emitted with the light intensity set for each site.

The illumination control unit 68E3 acquires the imaging position information from the system controller 100. The system controller 100 detects an imaging position based on a detection result from the second Z-axis position detector. Note that, in the present embodiment, an imaging position is a position (in-focus position) where the measurement object is in focus. The imaging position is synonymous with a measurement position. Since an in-focus position is known from the structure, the imaging position may be obtained from the position of the second imaging unit 60 in the Z-axis direction.

### [Mode of Operation]

### [Wafer Machining]

The wafer W is divided into chips by cutting along streets.

First, alignment is performed. As described above, the alignment is an operation of detecting positions of streets. After the alignment, machining is started.

First, the blade 41 is set to a predetermined height position and is rapidly rotated. The height position of the blade 41 is set so as to obtain a predetermined cutting-in depth. After setting the blade 41, the wafer W is subjected to cutting feeding (feeding in the X-axis direction). With this operation, the wafer W is cut (machined) along a street. After the cutting, the blade 41 is subjected to indexing (feeding in the Y-axis direction). This operation allows cutting (machining) along a next street. Cutting feeding and indexing are alternately performed in this manner to cut the wafer W. In a case where cutting (machining) for all streets is complete in a first direction, the wafer W is rotated by 90°, and cutting for all streets is performed in a second direction.

The dicing device 1 according to the present embodiment includes two spindles (the first spindle 42A and the second spindle 42B) and may simultaneously machine two streets.

A mode of cutting (machining) is not particularly limited. Machining may be performed in any mode, such as full cutting (machining for cutting a wafer deeply enough to reach the dicing tape DT so as to completely cut off the wafer) or half cutting (grooving for cutting a wafer till a middle of a thickness of the wafer).

### [Measurement of Kerf Shape]

A case where a shape of a formed kerf is measured will be described.

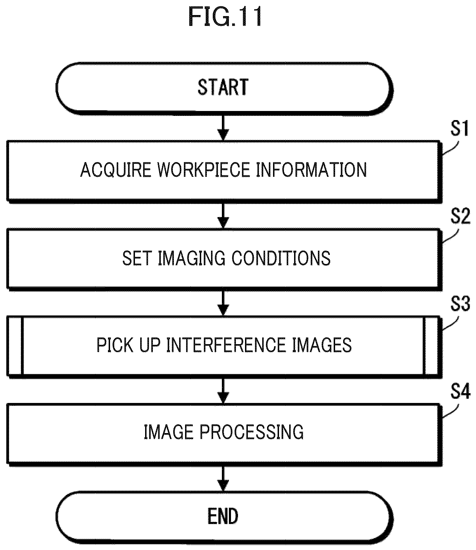

Figure 11 is a flowchart showing a procedure for a kerf shape measurement process.

First, workpiece information is acquired (step S1). As described above, the workpiece information includes information on the machining shape of the kerf C and information on the state of the bottom surface of the kerf C.

An imaging conditions are set based on the acquired workpiece information (step S2). In the present embodiment, light intensities of illumination light are set for imaging the respective sites (the first site Pz1, the second site Pz2, and the third site Pz3).

Then, interference images are picked up under the set imaging conditions (step S3).

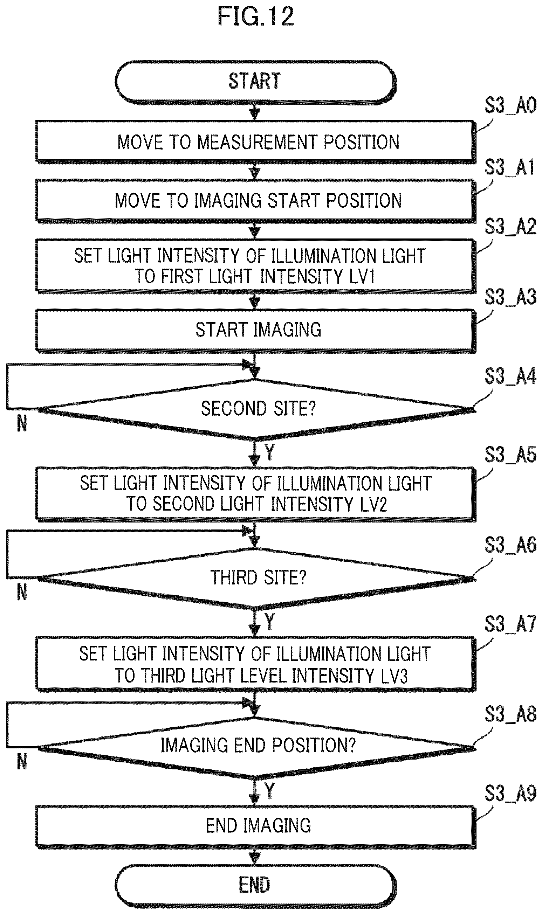

Figure 12 is a flowchart showing a procedure for an interference image pickup process.

First, a site to be measured in a kerf to be measured is moved to a measurement position (step S3_A0). That is, the site is moved to directly below the second imaging unit 60 (on an imaging optical axis).

Then, the second imaging unit 60 is moved to the imaging start position (step S3_A1). As described above, the imaging start position Z0 is set to a position at the predetermined height H from the surface of the wafer W (see Figure 9). Note that the position of the surface of the wafer W is measured in the course of alignment.

After the movement to the imaging start position, a light intensity of illumination light is set to the first light intensity LV1 (step S3_A2). After that, interference image pickup is started (step S3_A3). That is, interference image pickup is performed at a fixed interval while the second imaging unit 60 is moved at a fixed pitch downward in a vertical direction. More specifically, interference images are picked up with alternations of movement by a fixed pitch and imaging.

After the imaging is started, it is determined whether the imaging position reaches the second site Pz2 (step S3 _A4). In a case where it is determined that the imaging position does not reach the second site Pz2, imaging is carried on with the first light intensity LV1. On the other hand, in a case where it is determined that the imaging position reaches the second site Pz2, the light intensity of illumination light is switched to the second light intensity (step S3_A5). After that, imaging is performed with the second light intensity LV2.

After the light intensity of illumination light is switched to the second light intensity LV2, it is determined whether the imaging position reaches the third site Pz3 (step S3_A6). In a case where it is determined that the imaging position does not reach the third site Pz3, imaging is carried on with the second light intensity LV2. On the other hand, in a case where it is determined that the imaging position reaches the third site Pz3, the light intensity of illumination light is switched to the third light intensity (step S_A7). After that, imaging is performed with the third light intensity LV3.

After that, it is determined whether the imaging position reaches the imaging end position (step S3_A8). In a case where it is determined that the imaging position does not reach the imaging end position, imaging is carried on at the third light intensity LV3. On the other hand, in a case where it is determined that the imaging position reaches the imaging end position, the imaging ends (step S3_A9).

With the above-described series of steps, interference image pickup by the second imaging unit 60 ends. Interference images obtained by the imaging are sequentially output to the system controller 100.

The system controller 100 outputs the images obtained through the imaging to the image processing unit 110 and causes the image processing unit 110 to perform image processing (step S4). That is, the system controller 100 causes the image processing unit 110 to generate three-dimensional shape data of the object.

As has been described above, in the dicing device 1 according to the present embodiment, the light intensity of illumination light is changed in accordance with a site to be imaged in performing interference image pickup. This allows pickup of interference images with appropriate brightness. This also allows precise measurement of a kerf shape.

Note that, although a case where the site to be imaged is divided (classified) into three sites has been described above as an example, a mode of division of the site to be imaged is not limited to this. The dicing device 1 may be configured so as to divide the kerf more finely. Finer division allows finer control of the light intensity of illumination light.

When the kerf C is to be measured, it is preferable to set the light intensity of illumination light in accordance with a width (kerf width) of the kerf C.

### [Second Embodiment]

In the second present embodiment, a gain is automatically adjusted in accordance with a site to be imaged when picking up interference images by the second imaging unit 60.

Note that the present embodiment has the same configuration as that of the dicing device 1 according to the first embodiment except that interference image pickup conditions are different. Thus, only respects about control of interference image pickup will be described below.

Gain is adjusted by the analog signal processing unit 68B. The second camera control unit 68E controls the analog signal processing unit 68B such that gain is adjusted in accordance with settings determined for respective sites.

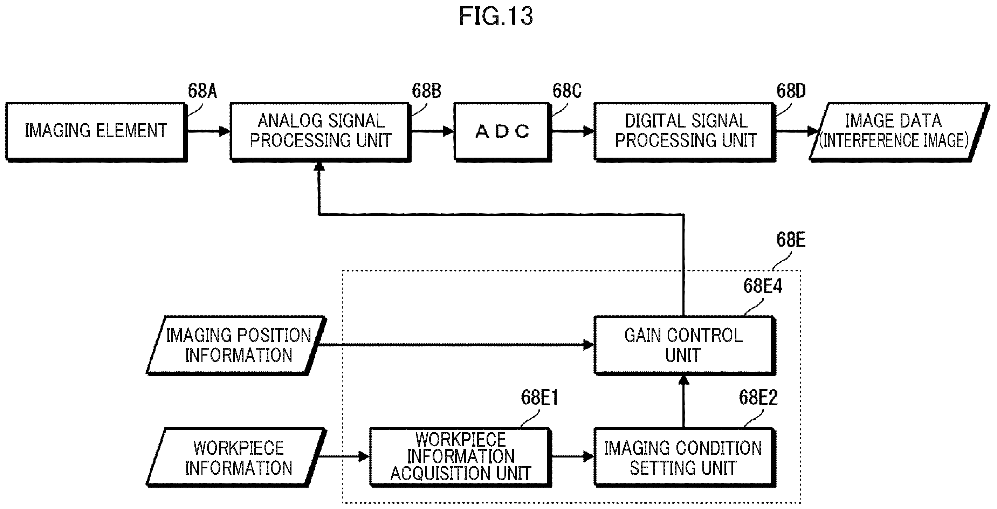

Figure 13 is a block diagram functions relating to gain control in the second camera control unit.

As shown in Figure 13, the second camera control unit 68E has functions of a workpiece information acquisition unit 68E1, an imaging condition setting unit 68E2, and a gain control unit 68E4.

The function of the workpiece information acquisition unit 68E1 is the same as in the first embodiment. That is, the workpiece information acquisition unit 68E1 acquires workpiece information.

The imaging condition setting unit 68E2 sets imaging conditions based on workpiece information. In the present embodiment, setting of a gain adjustment is determined for each site to be imaged. Setting of the sites is the same as in the first embodiment (see Figure 9).

Assume that a gain adjustment setting in imaging the first site Pz1 is "gain setting 1", a gain adjustment setting in imaging the second site Pz2 is "gain setting 2", and that a gain adjustment setting in imaging the third site Pz3 is "gain setting 3".

Imaging of the first site Pz1 is no different from ordinary cases where the measurement object is imaged in the air. Thus, the gain is set to gain setting 1 which is the same as a gain in an ordinary case where the measurement object in the air is imaged.

Imaging of the second site Pz2 is imaging of an inside of a kerf C. Thus, the gain is set to gain setting 2 which has a value higher than gain setting 1 (gain setting 1 < gain setting 2).

The third site Pz3 is imaging of a bottom surface of the kerf C. Thus, gain setting 3 is preferably set in accordance with a state of the bottom surface of the kerf C. In a case where the bottom surface is a smooth surface (there is reflected light from the bottom surface), the gain is set to gain setting 3 which has a value between gain setting 1 and gain setting 2 (gain setting 1 < gain setting 3 < gain setting 2). On the other hand, in a case where the bottom surface is not a smooth surface (there is little reflected light from the bottom surface or the bottom surface is darker than an inner wall surface of the kerf C) or in a case where a depth of the kerf C is deep (the depth is equal to or more than a threshold), the gain is set to gain setting 3 which has a value higher than gain setting 2 (gain setting 2 < gain setting 3).

Information on gain settings determined for each site is stored in, for example, a memory.

The gain control unit 68E4 controls the analog signal processing unit 68B in accordance with the gain settings set by the imaging condition setting unit 68E2. That is, the gain control unit 68E4 controls the analog signal processing unit 68B such that gain is adjusted based on the gain settings determined for each site.

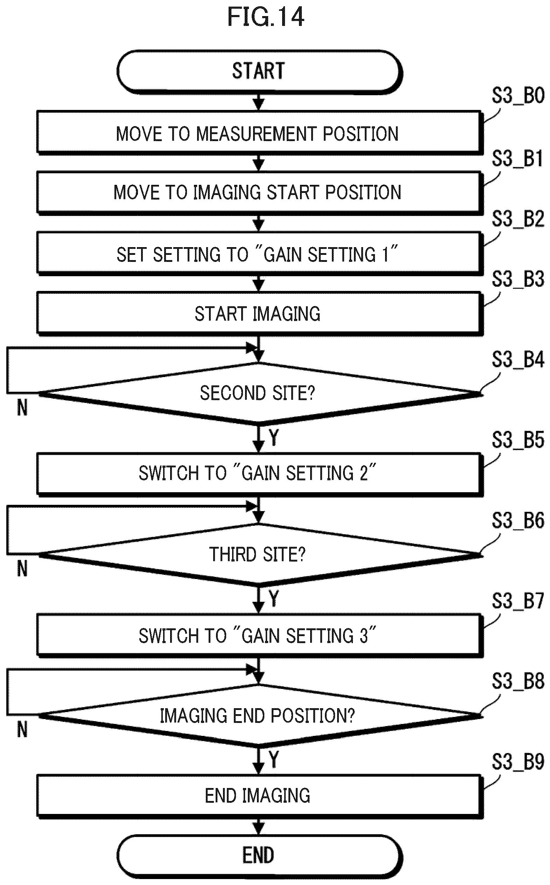

Figure 14 is a flowchart showing a procedure for an interference image pickup process.

First, a site to be measured in the kerf to be measured is moved to the measurement position (step S3_B0).

The second imaging unit 60 is moved to the imaging start position (step S3_B1).

After the movement to the imaging start position, the gain adjustment setting is set to gain setting 1 (step S3_B2), and interference image pickup is started (step S3_B3).

After the imaging is started, it is determined whether the imaging position reaches the second site Pz2 (step S3_B4). In a case where it is determined that the imaging position does not reach the second site Pz2, interference image pickup is carried on with gain setting 1 continuously used. That is, interference images are picked up in a state where the gain is adjusted to gain setting 1. On the other hand, in a case where it is determined that the imaging position reaches the second site Pz2, the gain adjustment setting is switched to "gain setting 2" (step S3_B5). After that, interference images are picked up in a state where the gain is adjusted to gain setting 2.

After the gain adjustment setting is switched to gain setting 2, it is determined whether the imaging position reaches the third site Pz3 (step S3_B6). In a case where it is determined that the imaging position does not reach the third site Pz3, interference image pickup is carried on with gain setting 2 continuously used. That is, interference images are picked up in a state where the gain is adjusted to gain setting 2. On the other hand, in a case where it is determined that the imaging position reaches the third site Pz3, the gain adjustment setting is switched to "gain setting 3" (step S_B7). After that, interference images are picked up in a state where the gain is adjusted to gain setting 3.

After that, it is determined whether the imaging position reaches the imaging end position (step S3_B8). In a case where it is determined that the imaging position does not reach the imaging end position, interference image pickup is carried on with gain setting 3 continuously used. That is, interference images are picked up in a state where the gain is adjusted to gain setting 3. On the other hand, in a case where it is determined that the imaging position reaches the imaging end position, the imaging ends (step S3_B9).

As has been described above, in the dicing device 1 according to the present embodiment, the gain adjustment setting is switched in accordance with a site to be imaged. This allows acquisition of images with appropriate brightness. This also allows precise measurement of a kerf shape.

Note that, although in dicing device 1 is configured such that gain adjustment is performed on an analog signal (so-called analog gain adjustment) in the present example, although in dicing device 1 may configured such that gain adjustment is performed on a digital signal (so-called digital gain adjustment).

In addition, the above-described example explains a case where a site to be imaged is divided (classified) into three sites; however, a mode of division of a site to be imaged is not limited to this. The dicing device 1 may be configured so as to divide the kerf more finely. Finer division allows finer control of the gain.

When the kerf C is to be measured, it is preferable to set the gain in accordance with a width (kerf width) of the kerf C.

### [Third Embodiment]

In the third embodiment, an exposure time is automatically adjusted in accordance with a site to be imaged in interference image pickup by the second imaging unit 60.

Note that the present embodiment has the same configuration as that of the dicing device 1 according to the above-described first embodiment except that an interference image pickup condition is different. Thus, only respects about control of interference image pickup will be described below.

By way of example, in the present embodiment, the imaging element 68A has a function of a so-called electronic shutter. The second camera control unit 68E controls the imaging element 68A such that image pickup is performed with exposure times respectively determined for sites.

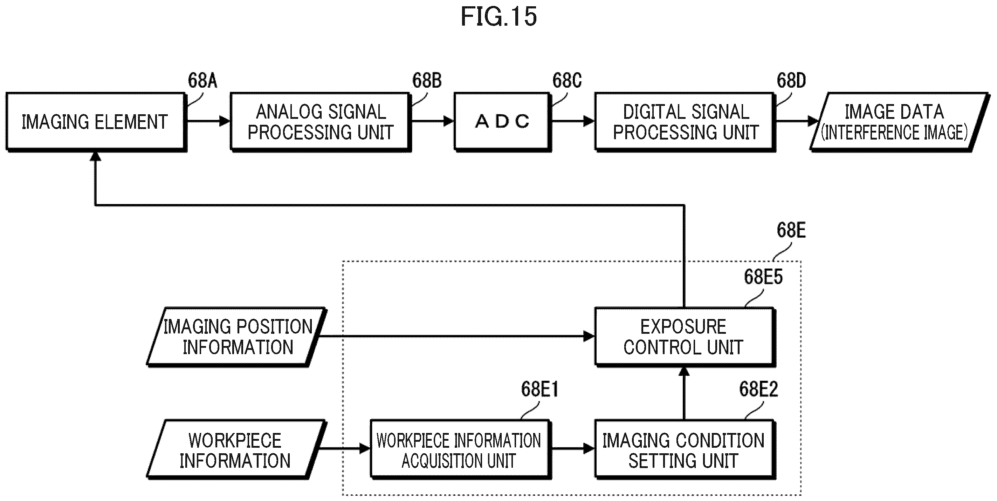

Figure 15 is a block diagram of functions relating to exposure time control in the second camera control unit.

As shown in Figure 15, the second camera control unit 68E has functions of a workpiece information acquisition unit 68E1, an imaging condition setting unit 68E2, and an exposure control unit 68E5.

The function of the workpiece information acquisition unit 68E1 is the same as in the first embodiment. That is, the workpiece information acquisition unit 68E1 acquires workpiece information.

The imaging condition setting unit 68E2 sets imaging conditions based on workpiece information. In the present embodiment, an exposure time at the time of imaging is determined for each of the sites to be imaged. Site setting is the same as in the first embodiment (see Figure 9).

Assume that an exposure time in imaging the first site Pz1 is a "first time T1", an exposure time in imaging the second site Pz2 is a "second time T2", and that an exposure time in imaging the third site Pz3 is a "third time T3".

Imaging of the first site Pz1 is no different from ordinary cases where the measurement object in the air is imaged. Thus, the first time T1 is set to the same exposure time as an exposure time in an ordinary case where the measurement object is imaged in the air.

Imaging of the second site Pz2 is imaging of an inside of a kerf C. Thus, the second time T2 is set to a time longer than the first time T1 (the first time T1 < the second time T2).

The third site Pz3 is imaging of a bottom surface of the kerf C. Thus, the third time T3 is preferably set in accordance with a state of the bottom surface of the kerf C. In a case where the bottom surface is a smooth surface (there is reflected light from the bottom surface), the third time T3 is set to a time between the first time T1 and the second time T2 (the first time T1 < the third time T3 < the second time T2). On the other hand, in a case where the bottom surface is not a smooth surface (there is little reflected light from the bottom surface or the bottom surface is darker than an inner wall surface of the kerf C) or in a case where a depth of the kerf C is deep (the depth is equal to or more than a threshold), the third time T3 is set to a time longer than the second time T2 (the second time T2 < the third time T3).

Information on exposure time settings determined for the respective sites is stored in, for example, a memory.

The exposure control unit 68E5 controls driving of the imaging element 68A in accordance with exposure time settings set by the imaging condition setting unit 68E2. That is, the exposure control unit 68E5 controls driving of the imaging element 68A such that exposure is performed with the exposure time determined for each site.

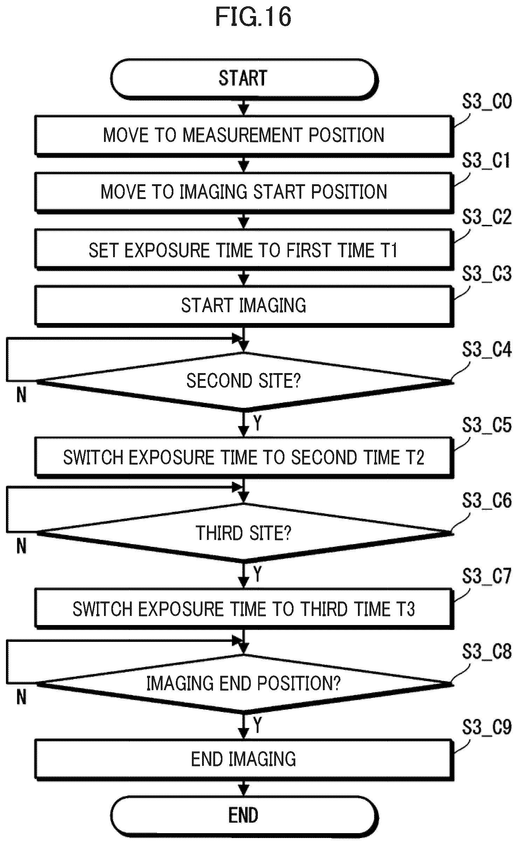

Figure 16 is a flowchart showing a procedure for an interference image pickup process.

First, a site to be measured in the kerf to be measured is moved to the measurement position (step S3_C0).

The second imaging unit 60 is moved to an imaging start position (step S3_C1).

After the movement to the imaging start position, the exposure time is set to the first time T1 (step S3_C2), and interference image pickup is started (step S3_C3).

After the imaging is started, it is determined whether the imaging position reaches the second site Pz2 (step S3_C4). In a case where it is determined that the imaging position does not reach the second site Pz2, interference image pickup is carried on in a state where the exposure time is continuously set to the the first time T1. On the other hand, in a case where it is determined that the imaging position reaches the second site Pz2, the exposure time is switched to the second time T2 (step S3_C5). After that, interface image pickup is performed in a state where the exposure time is set to the second time T2.

After the exposure time is switched to the second time T2, it is determined whether the imaging position reaches the third site Pz3 (step S3_C6). In a case where it is determined that the imaging position does not reach the third site Pz3, interference image pickup is carried on in a state where the exposure time is continuously set to the second time T2. On the other hand, in a case where it is determined that the imaging position reaches the third site Pz3, the exposure time is switched to the third time T3 (step S_C7). After that, interference image pickup is performed in a state where the exposure time is set to the third time T3.

After that, it is determined whether the imaging position reaches the imaging end position (step S3_C8). In a case where it is determined that the imaging position does not reach the imaging end position, interference image pickup is carried on in a state where the exposure time is continuously set to the third time T3. On the other hand, in a case where it is determined that the imaging position reaches the imaging end position, the imaging ends (step S3_C9).

As has been described above, in the dicing device 1 according to the present embodiment, the exposure time is switched in accordance with a site to be imaged. This allows acquisition of images with appropriate brightness. This also allows precise measurement of a kerf shape.

Note that, the above-described example explains a case where a site to be imaged is divided (classified) into three sites; however, a mode of division of a site to be imaged is not limited to this. The dicing device 1 may be configured so as to divide the kerf more finely. Finer division allows finer control of the exposure time.

When the kerf C is to be measured, it is preferable to set an exposure time in accordance with a width of the kerf C.

### [Fourth Embodiment]

In the fourth embodiment, a gradation is automatically adjusted in accordance with a site to be imaged in interference image pickup by the second imaging unit 60.

Note that the present embodiment has the same configuration as that of the dicing device 1 according to the above-described first embodiment except that an interference image pickup condition is different. Thus, only respects about control of interference image pickup will be described below.

Gradation correction is performed by the digital signal processing unit 68D. The second camera control unit 68E controls the digital signal processing unit 68D such that gradation correction is performed in accordance with settings determined for respective sites.

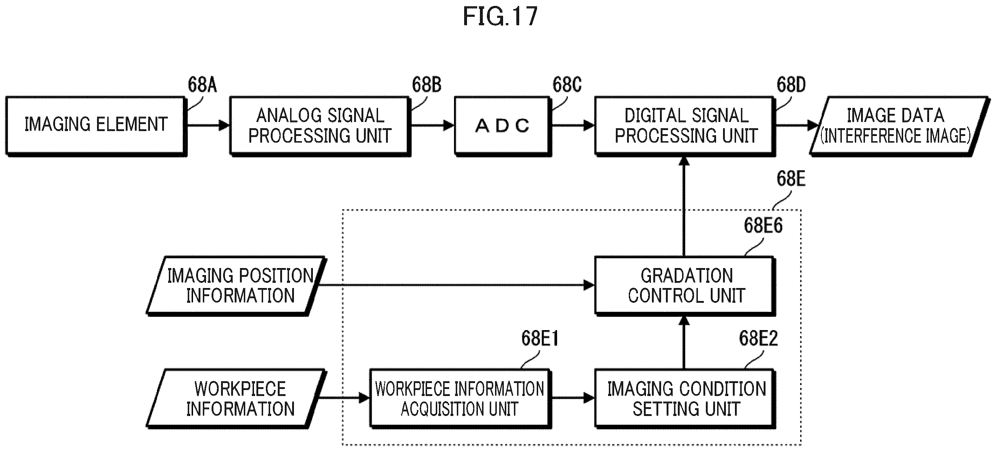

Figure 17 is a block diagram of functions relating to gradation correction control in the second camera control unit.

As shown in Figure 17, the second camera control unit 68E has functions of a workpiece information acquisition unit 68E1, an imaging condition setting unit 68E2, and a gradation control unit 68E6.

The function of the workpiece information acquisition unit 68E1 is the same as in the first embodiment. That is, the workpiece information acquisition unit 68E1 acquires workpiece information.

The imaging condition setting unit 68E2 sets imaging conditions based on workpiece information. In the present embodiment, setting of a gradation correction is determined for each site to be imaged. Setting of the sites is the same as in the first embodiment (see Figure 9).

Assume that a gradation correction setting in imaging the first site Pz1 is "gradation setting 1", a gradation correction setting in imaging the second site Pz2 is "gradation setting 2", and that a gradation correction setting in imaging the third site Pz3 is "gradation setting 3".

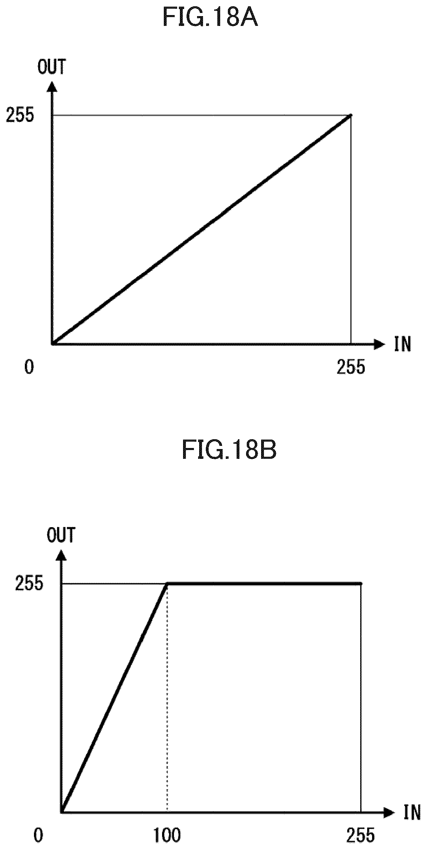

Figures 18A to 18D are graphs showing examples of the gradation correction setting. Figures 18A to 18D show examples of a case where an image to be picked up is an 8-bit image. That is, Figures 18A to 18D show examples of a case where an image is represented by 256 gradations.

Imaging of the first site Pz1 is no different from an ordinary case where the measurement object is imaged in the air. Thus, gradation setting 1 is set the same as gradation correction settings in an ordinary case where the measurement object is imaged in the air. Figure 18A shows an example of a gradation transformation characteristic of gradation setting 1. In this example, gradation setting 1 is set such that input and output have a linear relationship.

Imaging of the second site Pz2 is imaging of an inside of a kerf C. Thus, gradation setting 2 is set to a setting for imaging dark regions. Specifically, gradation setting 2 is set to a setting which amplifies dark input data. Figure 18B shows an example of a gradation transformation characteristic of gradation setting 2. In this example, gradation setting 2 is set so as to amplify dark input data. In the example shown in Figure 18B, gradation setting 2 is set such that output reaches a maximum (255) when input is 100.

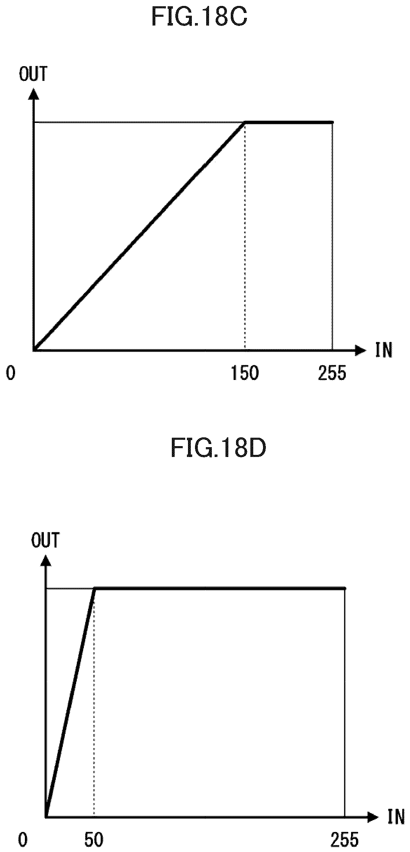

The third site Pz3 is imaging of a bottom surface of the kerf C. Thus, gradation setting 3 is preferably set in accordance with a state of the bottom surface of the kerf C. In a case where the bottom surface is a smooth surface (there is reflected light from the bottom surface), gradation setting 3 is set to a setting intermediate between gradation setting 1 and gradation setting 2. Figure 18C shows an example of a gradation transformation characteristic of gradation setting 3 in this case. In the example shown in Figure 18C, gradation setting 3 is set such that output reaches a maximum (255) when input is 150. On the other hand, in a case where the bottom surface is not a smooth surface (there is little reflected light from the bottom surface or the bottom surface is darker than an inner wall surface of the kerf C) or in a case where a depth of the kerf C is deep (the depth is equal to or more than a threshold), gradation setting 3 is set to a setting for imaging a region darker than a region which is imaged with gradation setting 2. Figure 18D shows an example of the gradation transformation characteristic of gradation setting 3 in this case. In the example shown in Figure 18D, gradation setting 3 is set such that output reaches a maximum (255) when input is 50.

Figures 18A to 18D show an example where an image to be picked up is an 8-bit image. In a case where an image to be picked up is a 14-bit image, an image is represented by 16,384 gradations (0 to 16,383).

Gradation correction is performed using, for example, a table (gradation transformation table), such as a lookup table (LUT). In this case, a gradation transformation table to be used is determined for each of the sites to be imaged.

Information on gradation correction settings (settings on a gradation transformation table to be used) determined for the respective sites is stored in, for example, a memory.

The gradation control unit 68E6 controls the digital signal processing unit 68D such that gradation correction is performed for each site in accordance with the gradation correction settings determined by the imaging condition setting unit 68E2.

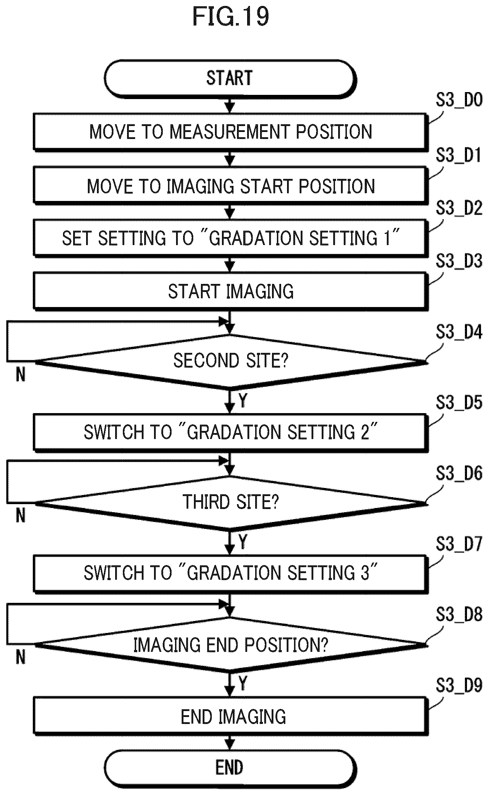

Figure 19 is a flowchart showing a procedure for an interference image pickup process.

First, a site to be measured in the kerf to be measured is moved to a measurement position (step S3_D0).

Then, the second imaging unit 60 is moved to the imaging start position (step S3_D1).

After the movement to the imaging start position, a gradation correction setting is set to "gradation setting 1" (step S3_D2), and interference image pickup is started (step S3_D3).

After the imaging is started, it is determined whether the imaging position reaches the second site Pz2 (step S3_D4). In a case where it is determined that the imaging position does not reach the second site Pz2, interference image pickup is carried on in a state where the gradation is continuously set to gradation setting 1. That is, the gradation correction is performed with gradation setting 1 to pick up interference images. On the other hand, in a case where it is determined that the imaging position reaches the second site Pz2, the gradation correction setting is switched to "gradation setting 2" (step S3_D5). After that, interface image pickup is performed in a state where the gradation is corrected with gradation setting 2.

After the gradation correction setting is switched to gradation setting 2, it is determined whether the imaging position reaches the third site Pz3 (step S3_D6). In a case where it is determined that the imaging position does not reach the third site Pz3, interference image pickup is carried on in a state where the gradation is continuously set to gradation setting 2. That is, gradation correction is performed with gradation setting 2 to pick up interference images. On the other hand, in a case where it is determined that the imaging position reaches the third site Pz3, the gradation correction setting is switched to "gradation setting 3" (step S_D7). After that, interface image pickup is performed in a state where the gradation is corrected with gradation setting 3.

After that, it is determined whether the imaging position reaches the imaging end position (step S3_D8). In a case where it is determined that the imaging position does not reach the imaging end position, interference image pickup is carried on in a state where the gradation is continuously set to gradation setting 3. That is, interface image pickup is performed in a state where the gradation is corrected with gradation setting 3. On the other hand, in a case where it is determined that the imaging position reaches the imaging end position, the imaging ends (step S3_D9).

As has been described above, in the dicing device 1 according to the present embodiment, a gradation correction setting is switched in accordance with a site to be imaged. This allows acquisition of images with appropriate brightness. This also allows precise measurement of a kerf shape.

Note that, the described above example explains a case where a site to be imaged is divided (classified) into three sites; however, a mode of division of a site to be imaged is not limited to this. The dicing device 1 may be configured so as to divide the kerf more finely. Finer division allows finer adjustment of the gradation of images to be picked up.

When the kerf C is to be measured, it is preferable to change the gradation correction setting in accordance with a width of the kerf C.

### [Fifth Embodiment]

In fifth present embodiment, an output range for pixel values (luminance values) is switched in accordance with a site to be imaged in interference image pickup by a second imaging unit 60.

Note that the present embodiment has the same configuration as that of the dicing device 1 according to the above-described first embodiment except that an interference image pickup condition is different. Thus, only respects about control of interference image pickup will be described below.

A process of adjusting the output range for pixel values is performed by the digital signal processing unit 68D. The second camera control unit 68E controls the digital signal processing unit 68D such that pixel values within an output range determined for each site are output.

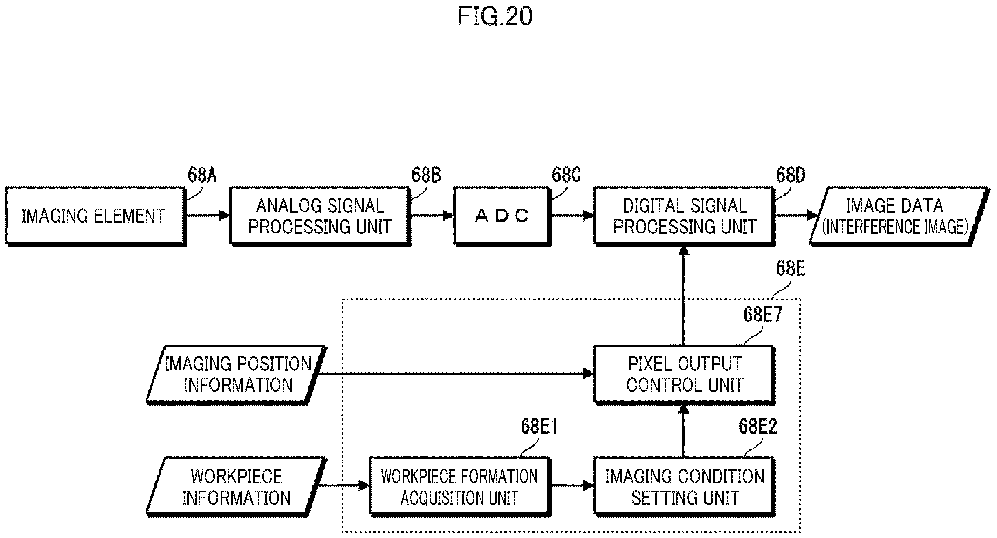

Figure 20 is a block diagram of functions relating to pixel value output control in the second camera control unit.

As shown in Figure 20, the second camera control unit 68E has functions of a workpiece information acquisition unit 68E1, an imaging condition setting unit 68E2, and a pixel output control unit 68E7.

The function of the workpiece information acquisition unit 68E1 is the same as in the above-described first embodiment. That is, the workpiece information acquisition unit 68E1 acquires workpiece information.

The imaging condition setting unit 68E2 sets an imaging condition based on workpiece information. In the present embodiment, an output range for pixel values is determined for each of the sites to be imaged. Setting of the sites is the same as in the first embodiment (see Figure 9).

Assume that an output range setting in imaging the first site Pz1 is "output setting 1", an output range setting in imaging a second site Pz2 is "output setting 2", and that an output range setting in imaging a third site Pz3 is "output setting 3".

Imaging of the first site Pz1 is no different from an ordinary case where the measurement object is imaged in the air. Thus, output setting 1 is set to the same setting as in an ordinary case where the measurement object is imaged in the air. For example, in the case of an 8-bit image (an image having pixel values of 0 to 255), output setting 1 is set so as to output pixel values equal to or more than 100 (a pixel value of 0 or NULL is output for a pixel having a pixel value less than 100).

Imaging of the second site Pz2 is imaging of an inside of a kerf C. Thus, output setting 2 is set to a setting for imaging dark regions. For example, in the case of an 8-bit image, output setting 2 is set so as to output a pixel value equal to or more than 0 and less than 100 (a pixel value of 0 or NULL is output for a pixel having a pixel value equal to or more than 100).

The third site Pz3 is imaging of a bottom surface of the kerf C. Thus, output setting 3 is preferably set in accordance with a state of the bottom surface of the kerf C. In a case where the bottom surface is a smooth surface (there is reflected light from the bottom surface), output setting 3 is set to a setting intermediate between output setting 1 and output setting 2. For example, in the case of an 8-bit image, output setting 3 is set so as to output a pixel value equal to or more than 50 and less than 150 (a pixel value of 0 or NULL is output for a pixel having a pixel value less than 50, and for a pixel having a pixel value equal to or more than 150). On the other hand, in a case where the bottom surface is not a smooth surface (there is little reflected light from the bottom surface or the bottom surface is darker than an inner wall surface of the kerf C) or in a case where a depth of the kerf C is deep (the depth is equal to or more than a threshold), output setting 3 is set to a setting for imaging a region darker than a region which is imaged with output setting 2. For example, in the case of an 8-bit image, output setting 3 is set so as to output a pixel value equal to or more than 0 and less than 50 (a pixel value of 0 or NULL is output for a pixel having a pixel value equal to or more than 50).

An output range for pixel values is controlled by, for example, filtering. In this case, a filter to be used is set for each site. Information on pixel value output range settings (settings on a filter to be used) determined for the respective sites is stored in, for example, a memory.

The pixel output control unit 68E7 controls the digital signal processing unit 68D such that pixel values are output in accordance with settings determined by the imaging condition setting unit 68E2. With restriction on an output range for pixel values, image data in which pixels under restriction have pixel values of 0 or NULL is generated.

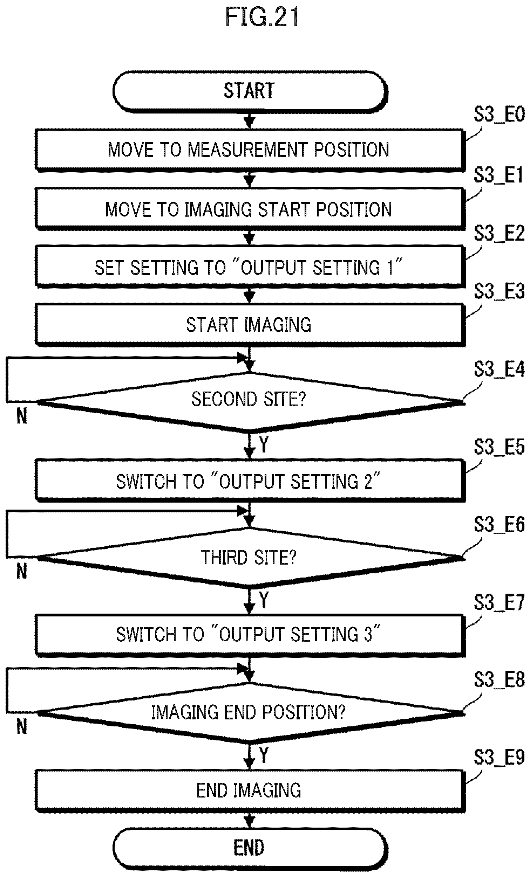

Figure 21 is a flowchart showing a procedure for an interference image pickup process.

First, a site to be measured in the kerf to be measured is moved to a measurement position (step S3_E0).

The second imaging unit 60 is moved to an imaging start position (step S3_E1).

After the movement to the imaging start position, the output range setting is set to "output setting 1" (step S3_E2), and interference image pickup is started (step S3_E3).

After the imaging is started, it is determined whether the imaging position reaches the second site Pz2 (step S3_E4). In a case where it is determined that the imaging position does not reach the second site Pz2, interference image pickup is carried on in a state where the output range setting is continuously set to output setting 1. That is, pixel values within the output range determined by output setting 1 are output. On the other hand, in a case where it is determined that the imaging position reaches the second site Pz2, the output range setting is switched to "output setting 2" (step S3_E5). After that, pixel values within the output range determined by output setting 2 are output.

After the output range setting is switched to output setting 2, it is determined whether the imaging position reaches the third site Pz3 (step S3_E6). In a case where it is determined that the imaging position does not reach the third site Pz3, interference image pickup is carried on in a state where the output range setting is continuously set to output setting 2. That is, pixel values within the output range determined by output setting 2 are output. On the other hand, in a case where it is determined that the imaging position reaches the third site Pz3, the output range setting is switched to "output setting 3" (step S_E7). After that, pixel values within the output range determined by output setting 3 are output.

After that, it is determined whether the imaging position reaches the imaging end position (step S3_E8). In a case where it is determined that the imaging position does not reach the imaging end position, interference image pickup is carried on in a state where the output range setting is continuously set to output setting 3. That is, pixel values within the output range determined by output setting 3 are output. On the other hand, in a case where it is determined that the imaging position reaches the imaging end position, the imaging ends (step S3_E9).

As has been described above, in the dicing device 1 according to the present embodiment, an output range for pixel values is restricted in accordance with a site to be imaged. This makes it possible to inhibit a noise component from being included in images. This also allows precise measurement of a kerf shape.

Note that, the described above example explains a case where a site to be imaged is divided (classified) into three sites; however, a mode of division of a site to be imaged is not limited to this. The dicing device 1 may be configured so as to divide the kerf more finely. Finer division allows finer control of an output range for pixel values.

When the kerf C is to be measured, it is preferable to set an output range for pixel values in accordance with a width of the kerf C.

### [Sixth Embodiment]

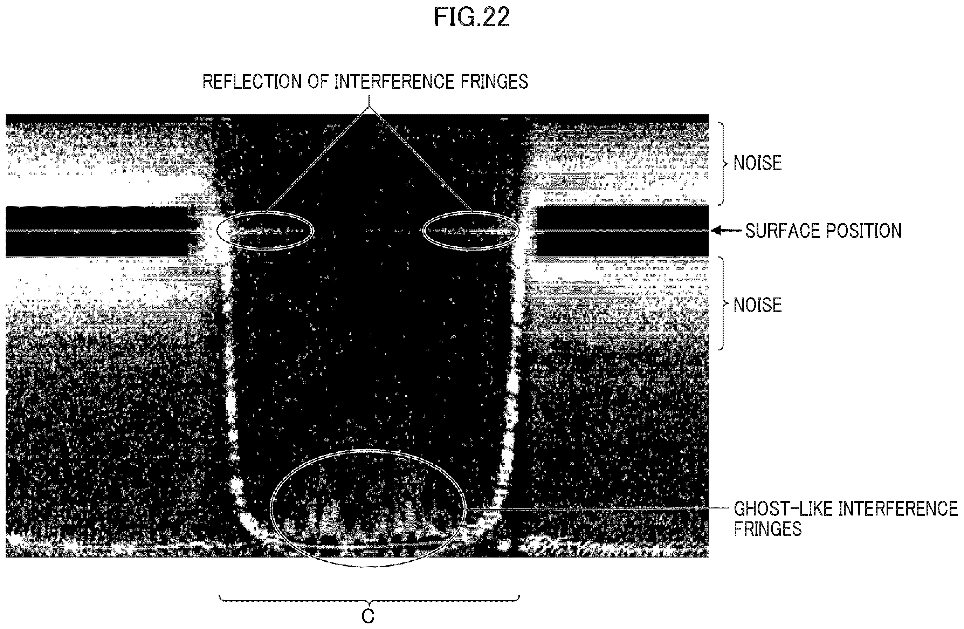

Figure 22 is an illustration showing an example of a result of measuring of a kerf in a wafer by a white-light interferometer. Figure 22 is a figure obtained by projecting three-dimensional shape data onto a two-dimensional section (a YZ cross-section of a kerf C).

As shown in Figure 22, in a case where the kerf C machined in a surface of the wafer is measured by a white-light interferometer, noise may be generated near the surface of the wafer W. Interference fringes may reflect inside the groove near the surface. In addition, ghost-like interference fringes may appear inside the groove.

Such noise and interference fringes appearing in an intrinsically blank region become a destabilizing factor or a misdetection factor in extracting an intrinsic shape.

Under the circumstances, in the present embodiment, only a region necessary for shape extraction is extracted from the picked-up interference images, and the extracted image is output as a picked-up image to a system controller 100. That is, a region unnecessary for measurement is cut out, before outputting the picked-up images. This allows elimination of a destabilizing factor or a misdetection factor in extracting an intrinsic shape.

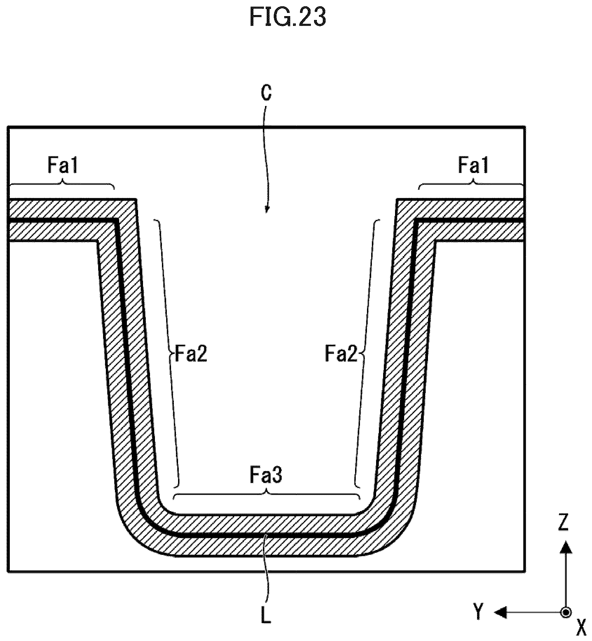

Figure 23 is a conceptual diagram of setting of an output range in an image.

Figure 23 shows an example of a case where a shape of the kerf C is measured. In Figure 23, a thick line L indicates a contour shape of a cross-section (YZ cross-section) of the kerf C. A shaded region (hatched region) indicates an example of the output range to be set.

In measuring the kerf C, positions of surfaces Fa1 of the wafer, inner wall surfaces Fa2 of the kerf C, and a bottom surface Fa3 of the kerf C are extracted from an image. Thus, a range including these surfaces are set as the output range (image output range) of the image. In the example shown in Figure 23, the output range is a range within a uniform (fixed) width centered on a position of each surface to be extracted. This allows extraction and output of only a region necessary for shape extraction.

The setting of the image output range and control of the setting are performed by, for example, the second camera control unit 68E. The second camera control unit 68E sets an image output range based on, for example, workpiece information.

A process of adjusting an image output range is performed by a digital signal processing unit 68D. The second camera control unit 68E controls the digital signal processing unit 68D such that an image is output in accordance with a setting.

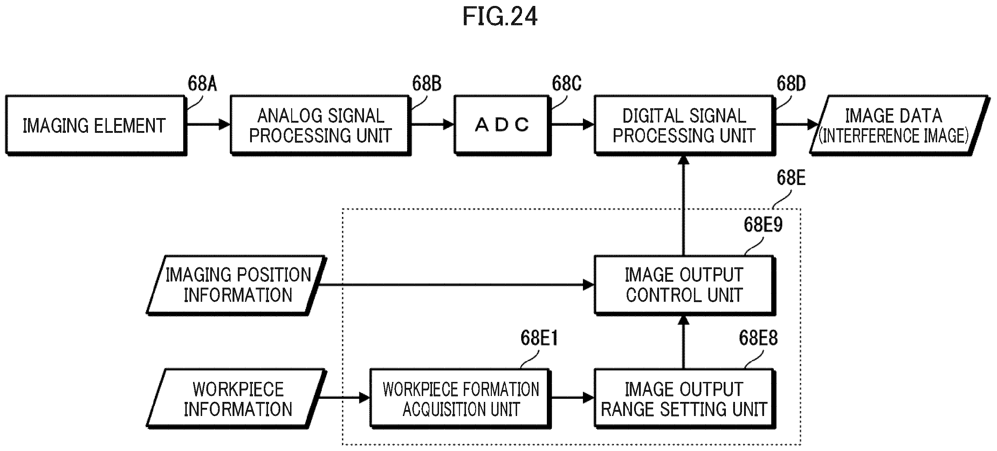

Figure 24 is a block diagram of functions which the second camera control unit has for image output control.

As shown in Figure 24, the second camera control unit 68E has functions of a workpiece information acquisition unit 68E1, an image output range setting unit 68E8, and an image output control unit 68E9.

The function of the workpiece information acquisition unit 68E1 is the same as in the above-described first embodiment. That is, the workpiece information acquisition unit 68E1 acquires workpiece information.

The image output range setting unit 68E3 sets an image output range based on workpiece information. The image output range is set for each imaging position in the Z-axis direction.

As described above, the image output range is set so as to include surfaces to be extracted (the surface of the wafer W, the inner wall surfaces of the kerf C, or the bottom surface of the kerf C) (see Figure 23). For example, a range within a uniform width with respect to a position of each surface to be extracted is set as the image output range. The image output range is set based on information on a machining shape of the kerf C (information on a shape of a cross-section of the kerf C).

The image output control unit 68E9 controls the digital signal processing unit 68D such that an image is output in accordance with the output range setting set by the image output range setting unit 68E8. That is, the image output control unit 68E9 controls the digital signal processing unit 68D so as to output an image within the output range determined for each imaging position in the Z-axis direction.

The digital signal processing unit 68D outputs an image in which pixels outside the output range are set to have pixel values of 0 or NULL. The output image is added to the image processing unit 110 in order to generate three-dimensional shape data.

As described above, in the present embodiment, only a region necessary for shape extraction is extracted from picked-up interference images, and the images after the extraction are output as picked-up images. The region unnecessary for measurement is cut before outputting the picked-up images. This allows elimination of a destabilizing factor or a misdetection factor when extracting an intrinsic shape, thereby implementing stable measurement.

Note that, the above-described example explains a process of adjusting the image output range performed by a second imaging unit 60 side; however, the same process may be performed by a unit different from the second imaging unit 60. For example, the process may be performed by the system controller 100. Alternatively, the process may be performed by a separately provided unit or by the image processing unit 110.

### [Seventh Embodiment]

In the seventh embodiment, an image output range is automatically set based on a picked-up image. Specifically, a position of an interface in a measurement object (or an intersection between a predetermined surface and another surface intersecting the surface) is recognized from a picked-up interference image, and an output range is automatically set. In the case of a kerf C, positions of a surface of a wafer W, inner wall surfaces of the kerf C, and a bottom surface of the kerf C are recognized from picked-up interference images to set output ranges.

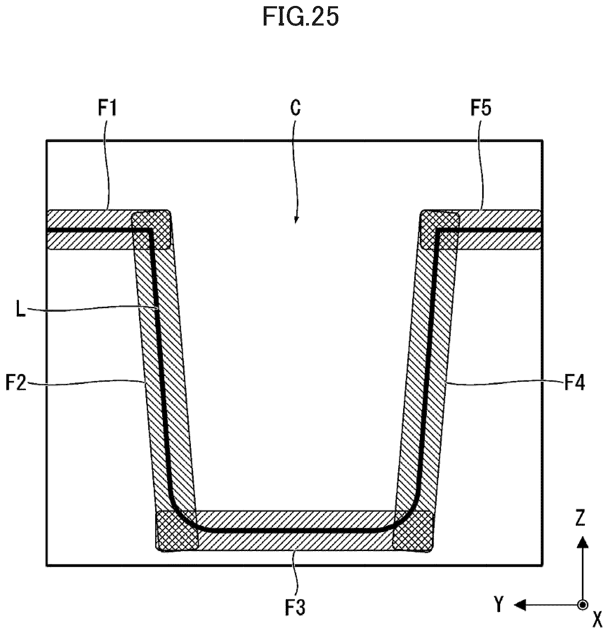

Figure 25 is a conceptual diagram of setting of an image output range.

Figure 25 shows an example of a case where a shape of the kerf C is measured. In Figure 25, a thick line L indicates a contour shape of a cross-section (YZ cross-section) of the kerf C.

In the case of the kerf C, the surface of the wafer, the inner wall surfaces of the kerf C, and the bottom surface of the kerf C are set as extraction objects. Thus, a certain range covering the surface of the wafer, the inner wall surfaces of the kerf C, and the bottom surface of the kerf C is set as image output ranges. In the present embodiment, a range within a uniform width centered on a position of each surface is set as an image output range.

In Figure 25, ranges indicated by rectangular frames F1 and F5 are image output ranges which are set for the surface of the wafer. Ranges indicated by rectangular frames F2 and F4 are image output ranges which are set for the inner wall surfaces of the kerf C. A range indicated by a rectangular frame F3 is an image output range which is set for the bottom surface of the kerf C. The frames F1 to F5 have a configuration in which adjacent frames are connected end to end. For example, the frame F2 connects one end of the frame F1 and one end of the frame F3, and the frame F4 connects one end of the frame F5 and the other end of the frame F3.

In the present embodiment, the frames F1 to F5 are set on surfaces (the surface of the wafer, the inner wall surfaces of the kerf C, and the bottom surface of the kerf C) recognized from images, to dynamically set image output ranges.

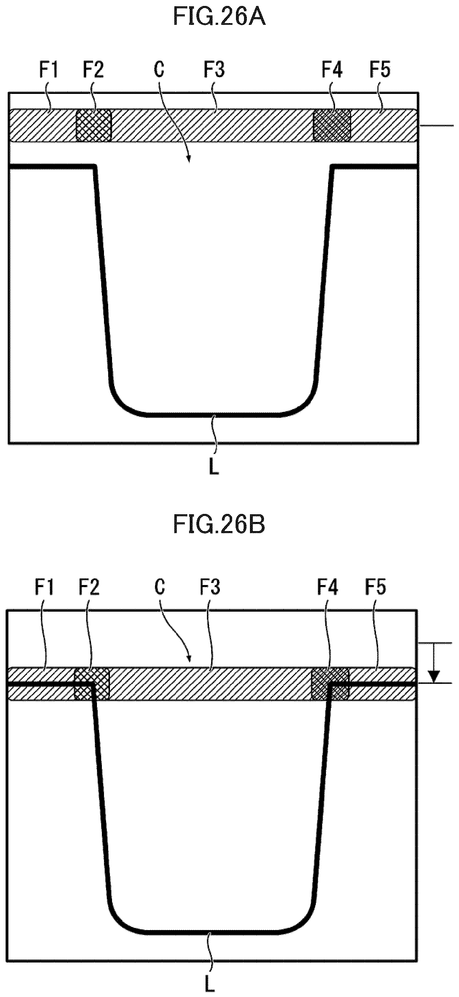

Figures 26A to 26D are conceptual diagrams of frame setting.

Figure 26A shows a setting state of the frames F1 to F5 at the start of imaging. At the start of imaging, the frames F1 to F5 are lined up side by side.

The frames F1 to F5 move in conjunction with movement of the imaging position.

Figure 26B shows a setting state of the frames F1 to F5 when the surface of the wafer is recognized. When the position of the surface of the wafer is recognized from an image, movement of the frames F1 and F5 is stopped. Edge positions are adjusted. This determines image output ranges to be set for the surface of the wafer.

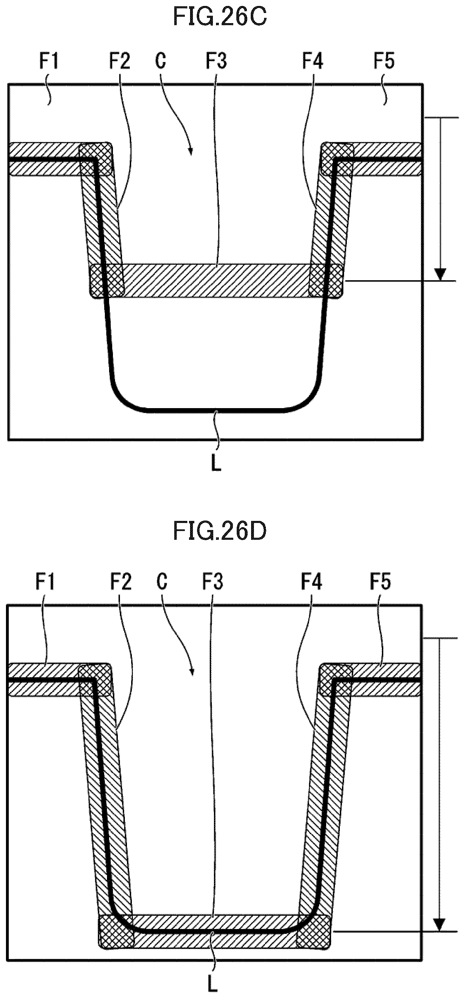

Figure 26C shows a setting state of the frames F1 to F5 while the inner wall surfaces of the kerf C are imaged. The frames F2 and F4 are constructed as stretchable frames (so-called rubber bands). When the position of the surface of the wafer is recognized as described above, the frames F1 and F5 are stopped from moving. The frames F2 to F4 continue to move in conjunction with movement of the imaging position. At this time, the frames F2 and F4 extend between the frames F1 and F5 and the frame F3. In this extension, inclinations of the frames F2 and F4 are adjusted with respect to the positions of the inner wall surfaces of the kerf C recognized from images. This determines image output ranges to be set for the inner wall surfaces of the kerf C.

Figure 26D shows a setting state of the frames F1 to F5 when the bottom surface of the kerf C is recognized. When the position of the bottom surface of the kerf C is recognized from an image, the frame F3 is stopped from moving. This determines an image output range set for the bottom surface of the kerf C.

As described above, in the present embodiment, surfaces as extraction objects (the surface of the wafer, the inner wall surfaces of the kerf C, and the bottom surface of the kerf C) are recognized from images, and the frames F1 to F5 are set so as to dynamically set image output ranges. In other words, positions of interfaces are tracked, the frames F1 to F5 are set, and the image output ranges are set.

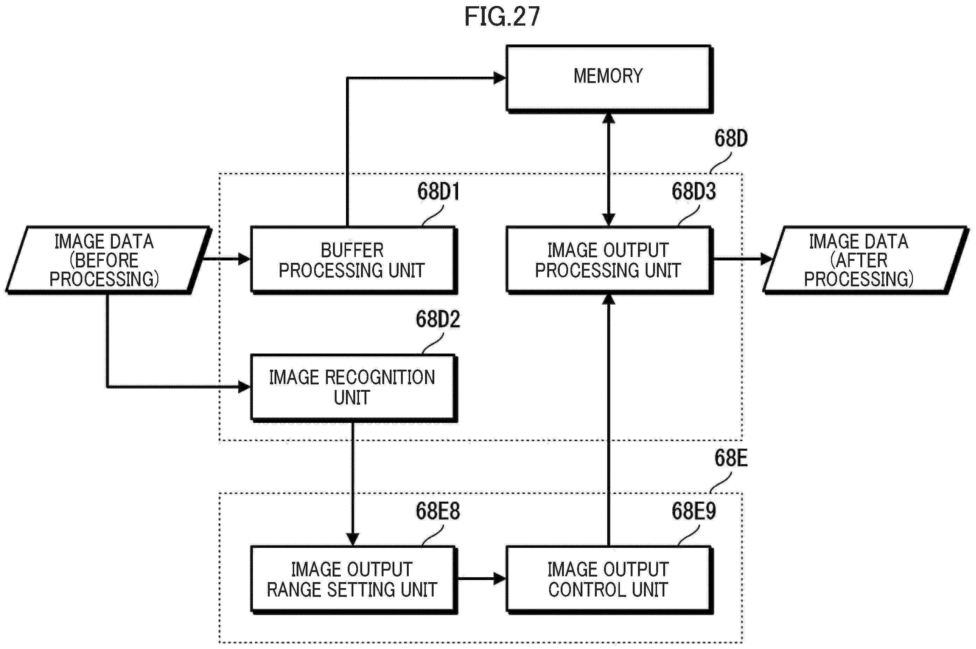

Figure 27 is a block diagram of a control system for image output.

The second camera control unit 68E and the digital signal processing unit 68D perform image output control in cooperation. As for the image output control, the second camera control unit 68E has functions of an image output range setting unit 68E8 and an image output control unit 68E9. The digital signal processing unit 68D has functions of a buffer processing unit 68D1, an image recognition unit 68D2, and an image output processing unit 68D3.

The buffer processing unit 68D1 buffers image data to be processed. That is, the buffer processing unit 68D1 performs a process of temporarily storing the image data in a memory. The image data is stored in chronological order in the memory.

The image recognition unit 68D2 analyzes picked-up images to recognize surfaces to be extracted. Since the kerf C is a measurement object in the present embodiment, the surface of the wafer W, the inner wall surfaces of the kerf C, and the bottom surface of the kerf C are recognized. A publicly known approach may be adopted for the image recognition. For example, regarding the surface of the wafer W, it is possible to adopt, an approach of recognizing a surface of the wafer W, when the number of points with high interference intensity inside the frame F1 or F5 reaches a state recognizable as a surface (the number of points, an area (planar dimension), or a feature amount of an approximate line based on Hough transform or the like are used for recognition). Similarly, regarding the bottom surface of the kerf C, it is possible to adopt an approach of recognizing a bottom surface, when the number of points with high interference intensity inside F3 reaches a state recognizable as a bottom surface. Regarding each inner wall surface of the kerf C, an angle of a region is analyzed from a sequence of candidate points (using, for example, the inclination of a Hough line, the inclination of a least square line, or the inclination of a long axis of a sequence of points) to obtain an inclination angle.

The image output range setting unit 68E8 sets an image output range based on a result of recognizing surfaces to be extracted by the image recognition unit 68D2. In the present embodiment, the image output range setting unit 68E8 sets the frames F1 to F5 to set respective image output ranges at the surfaces (the surface of the wafer, the inner wall surfaces of the kerf C, and the bottom surface of the kerf C).

The image output control unit 68E9 causes the image output processing unit 68D3 to perform an image output process based on output ranges set by the image output range setting unit 68E8.

The image output processing unit 68D3 processes image data stored in the memory based on an instruction from the image output control unit 68E9 to generate image data to be output. That is, the image output processing unit 68D3 extracts images within set output ranges, to generate image data to be output. As the image data to be output, an image in which pixels outside the output ranges are set to have pixel values of 0 or NULL, is generated.

As described above, in the present embodiment, picked-up images are recognized to set image output ranges. Thus, it is possible to appropriately set output ranges.

In the above-described example, each of the frames F2 and F4 that set output ranges for the inner wall surfaces of the kerf C is provided with a stretchable frame; however, the frames may also be formed with a so-called multi-joint frame.

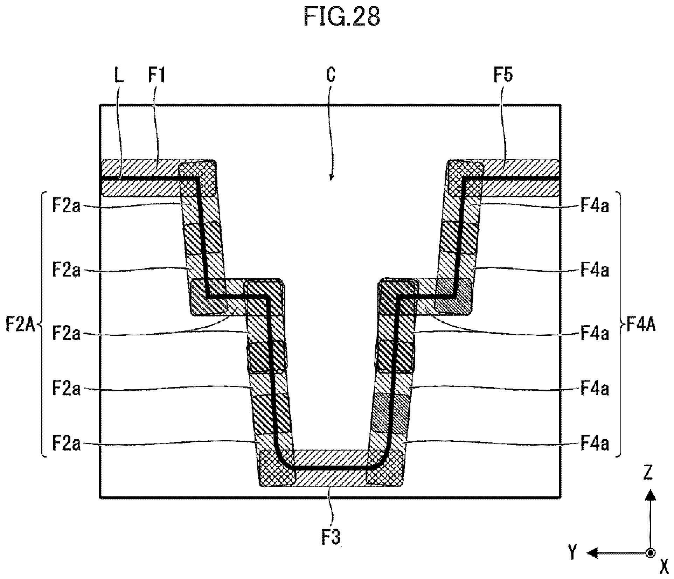

Figure 28 is a diagram showing an example of a case where an image output range is set using a multi-joint frame.

Figure 28 shows an example of a case where a shape of a kerf machined by step cutting is measured. In step cutting, after half cutting, an inside of a half-cut part is subjected to full cutting. For this reason, a cross-section of the kerf C has a stepped part.

Multi-joint frames F2A and F4A are formed by continuously generating frames F2a and F4a, and each of frames F2a and F4a has a uniform length. Adjacent frames F2a are connected to each other so as to be bendable, and adjacent frames F4a are connected to each other so as to be bendable. With this configuration, it is possible to set the frames F2A and F4A that fit more closely to the shape of the cross-section. The frames F2A and F4A are effective particularly in a case where each inner wall surface is not in a straight-line shape (a case where the inner wall surface has a stepped part, the inner wall surface is a curved surface, and so on) as in the kerf C in the present example.

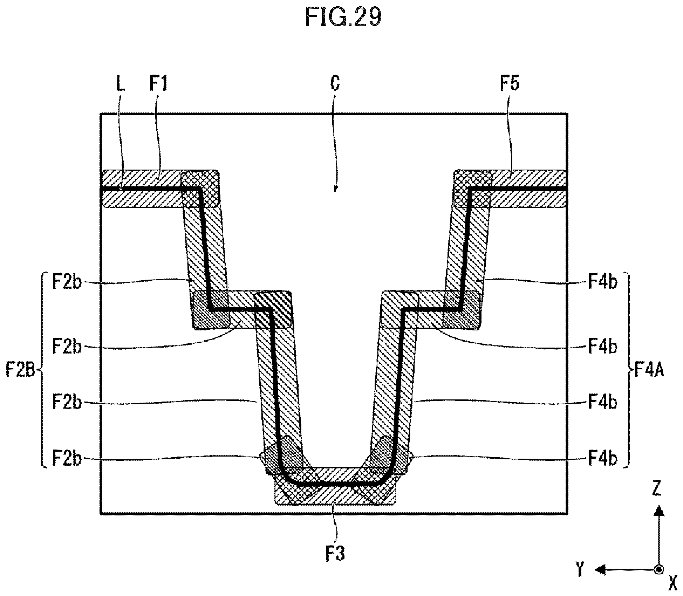

Figure 29 is a diagram showing another example of frames for setting the image output range.

The example shown in Figure 29 shows an example of a case where a frame is divided at every extreme point, and divided frames are set. Regarding frames F2B and F4B for setting output ranges for the inner wall surfaces of the kerf C, frames F2B and F4B are configured to be stretchable; however, extension of each of the frames F2B and F4B is stopped at every extreme point, and a new frame is generated. In the example shown in Figure 29, a frame F2b or F4b is stopped extending at each of an endpoint of a stepped part and an endpoint of a curved surface serving as extreme points, and a new frame F2b or F4b is generated. With this configuration, it is possible to set the frames F2B and F4B so as to fit to the shape of the cross-section.

Note that, although widths of frames are uniform in the above-described examples, a width of a frame may be set in accordance with, e.g., the inclination of a surface as a measurement object.

In a case where workpiece information may be acquired, the frames F1 to F5 are preferably set using the workpiece information. For example, for the frames F1 to F5 in an initial stage, widths and lengths are preferably set using the workpiece information. Recognition of surfaces is preferably performed using the workpiece information.

Additionally, images to be used for image recognition are preferably images picked up by performing the above-described imaging control. This facilitates image recognition.

Although a process of adjusting an image output range is performed by the second imaging unit 60 in the above examples, the same process may be performed by a unit other than the second imaging unit 60.

Although an image output range is used in the above, a least square line, a Hough line, or a principal axis may be output as an interface (= sectional shape region).

### [Other Embodiments]

The above-described embodiments may be appropriately combined and carried out. That is, it is possible to perform adjustment of a light intensity of illumination light, gain adjustment, gradation correction, exposure time adjustment, adjustment of an output range for pixel values, and the like in appropriate combinations. It is also possible to perform image output range adjustments in appropriate combinations.

Imaging conditions set for the respective sites for performing image pickup through scanning in the Z-axis direction is not limited to the ones in the above-described embodiments, and various conditions may be set.

Although a process of generating three-dimensional shape data is performed by the image processing unit 110 different from the second imaging unit 60 in the above-described embodiments, the second imaging unit 60 may be provided with the function of the image processing unit 110.

Although above-described examples explain cases where the second imaging unit 60 is provided with a white-light interferometer in the embodiments, the present invention may also be applied to a case where the second imaging unit 60 is provided with a shape measuring device using a different optical interferometry. As an interference optical system, an interference optical system of a Michelson type, a Fizeau type, or the like may also be adopted, other than interference optical system of a Mirau type.

Further, the present invention may also be applied to a case where the second imaging unit 60 is provided with a laser microscope (an optical system microscope using a laser as an illumination light source and using a confocal scheme for an optical system) or a case where imaging is performed by a focus variation method.

Although the above- described examples explain cases where the present invention is applied to a so-called twin-spindle dicer in the embodiments, application of the present invention is not limited to this. The number of spindles to be mounted on the device may be one or three or more. Although the above- described examples explain cases where a semiconductor wafer is machined in the embodiments, a machining object (workpiece) is not limited to this.

Although a drive unit for the second imaging unit 60 is made to double as a drive unit for the second machining unit 40B in the above-described embodiments, independent drive units may be provided for the units. Alternatively, a separate measurement unit may be provided in the device, and measurement may be performed by the measurement unit.

Although the second imaging unit 60 is moved in performing image pickup through scanning in the Z-axis direction in the above-described embodiments, the device may be configured so as to move the table 10 instead of the second imaging unit 60. Alternatively, the device may be configured so as to move both of the second imaging unit 60 and the table 10. That is, the second imaging unit 60 only needs to be configured to be movable along the Z-axis direction relative to a workpiece on the table 10.

### Reference Signs List

1: dicing device, 2: base, 3: column, 10: table, 10A: holding surface, 11: table drive unit, 30X: X-axis feed mechanism, 30YA: first Y-axis feed mechanism, 30YB: second Y-axis feed mechanism, 30ZA: first Z-axis feed mechanism, 30ZB: second Z-axis feed mechanism, 31X: X-axis guide rail, 31YA: first Y-axis guide rail, 3 1YB: second Y-axis guide rail, 31ZA: first Z-axis guide rail, 31ZB: second Z-axis guide rail, 32X: X-axis table, 32YA: first Y-axis table, 32YB: second Y-axis table, 32ZA: first Z-axis table, 32ZB: second Z-axis table, 33X: X-axis actuator, 33YA: first Y-axis actuator, 33YB: second Y-axis actuator, 33ZA: first Z-axis actuator, 33Z:B second Z-axis actuator, 40A: first machining unit, 40B: second machining unit, 41: blade, 42A: first spindle, 42B: second spindle, 43A: first spindle motor, 43B: second spindle motor, 44A: bracket, 44B: bracket, 50: first imaging unit, 51: first microscopic unit, 52: illumination unit, 52A: illumination light source, 52B: illumination lens, 53: beam splitter, 54: objective lens, 55: imaging lens, 56: first camera unit, 56A: imaging element, 56B: analog signal processing unit, 56D: digital signal processing unit, 56E: first camera control unit, 60: second imaging unit, 60B: second imaging unit, 61: second microscopic unit, 62: illumination unit, 62A: illumination light source, 62B: illumination lens, 63: first beam splitter, 64: objective lens, 65: glass plate, 65A: reference mirror, 66: second beam splitter, 67: imaging lens, 68: second camera unit, 68A: imaging element, 68B: analog signal processing unit, 68D: digital signal processing unit, 68D1: buffer processing unit, 68D2: image recognition unit, 68D3: image output processing unit, 68E: second camera control unit, 68E1: workpiece information acquisition unit, 68E2: imaging condition setting unit, 68E3: illumination control unit, 68E4: gain control unit, 68E5: exposure control unit, 68E6: gradation control unit, 68E7: pixel output control unit, 68E8: image output range setting unit, 68E9: image output control unit, 100: system controller, 110: image processing unit, 110A: alignment unit, 110B: kerf check unit, 110C: kerf shape measurement unit, 120: operation unit, 130: display unit, 140: communication unit, C: kerf, DF: dicing frame, DT: dicing tape, F1: frame, F2: frame, F2A: frame, F2B: frame, F2a: frame, F2b: frame, F3: frame, F4: frame, F5: frame, Fa1: surface of wafer, Fa2: inner wall surface of kerf, Fa3: bottom surface of kerf, L: contour shape of section of kerf, W: wafer, Z0: imaging start position, Z1: position of surface of wafer, Z2: position of bottom surface of kerf, ZE: imaging end position

## Claims

1. A machining device comprising:
a table configured to hold a workpiece on a holding surface perpendicular to a Z-axis;
a machining unit configured to machine the workpiece on the table;
an imaging unit configured to image a surface of the workpiece using an optical interferometry;
a drive unit configured to move the imaging unit relative to the table, along a direction of the Z-axis; and
an imaging control unit configured to control the drive unit and the imaging unit to image the surface of the workpiece on the table through scanning in the direction of the Z-axis,
wherein the imaging control unit picks up an image of the surface of the workpiece through scanning in the direction of the Z-axis, in accordance with an imaging condition determined for each site to be imaged.

2. The machining device according to claim 1, wherein the imaging control unit applies illumination light having a light intensity determined for each site, to pick up the image of the surface of the workpiece.

3. The machining device according to claim 1, wherein the imaging control unit performs gain adjustment based on a setting determined for each site, to pick up the image of the surface of the workpiece.

4. The machining device according to claim 1, wherein the imaging control unit controls an exposure time based on a setting determined for each site, to pick up the image of the surface of the workpiece.

5. The machining device according to claim 1, wherein the imaging control unit performs gradation correction based on a setting determined for each site, to pick up the image of the surface of the workpiece.

6. The machining device according to claim 1, wherein the imaging control unit outputs from each pixel, a pixel value falling within an output range determined for each site, to pick up the image of the surface of the workpiece.

7. The machining device according to claim 1, wherein,
in a case where a groove machined on the surface of the workpiece is to be imaged, the groove is classified into a first site including the surface of the workpiece, a third site including a bottom surface of the groove, and a second site between the first site and the third site, and
the imaging condition is determined for each of the classified sites.

8. The machining device according to claim 1, further comprising
an image processing unit configured to process the image picked up through scanning in the direction of the Z-axis, and measure a shape of the surface of the workpiece.

9. The machining device according to any one of claims 1 to 8, further comprising:
a workpiece information acquisition unit configured to acquire workpiece information including information on a shape of a cross-section of the workpiece; and
an imaging condition setting unit configured to set the imaging condition based on the workpiece information.

10. The machining device according to claim 9, further comprising
an output range setting unit configured to set an image output range, based on the information on the shape of the cross-section of the workpiece, wherein
the imaging control unit extracts an image within the image output range set by the output range setting unit from the picked up image, and outputs the extracted image.

11. The machining device according to any one of claims 1 to 8, further comprising
an output range setting unit configured to analyze the picked up image and set an output range, wherein
the imaging control unit extracts an image within the output range set by the output range setting unit from the picked up image, and outputs the extracted image.

12. The machining device according to claim 11, wherein
the output range setting unit analyzes the picked up image to recognize an interface on the workpiece, and sets a predetermined range including the recognized interface, as the output range.

13. The machining device according to claim 12, wherein,
in a case where a groove machined on the surface of the workpiece is to be imaged, the output range setting unit recognizes the surface of the workpiece, an inner wall surface of the groove and a bottom surface of the groove, and sets a predetermined range including the recognized surfaces, as the output range.

14. The machining device according to any one of claims 1 to 8, wherein
the imaging unit images the surface of the workpiece using a white-light interferometry.
